# EUROPEAN PATENT APPLICATION

(11) **EP 4 571 824 A1**
(43) Date of publication of application: **18.06.2025**
(21) Application number: 24185606.1
(22) Date of filing: 01.07.2024
(51) Int. Cl.: H01L 21/822, H01L 21/8234, H01L 27/06, H01L 27/088, H01L 29/06, H01L 29/417, H01L 29/66, H01L 29/775

(54) **SEMICONDUCTOR DEVICE**

(30) Priority: 15.12.2023 KR 20230182786
(71) Applicant: Samsung Electronics Co., Ltd., Suwon-si, Gyeonggi-do 16677 (KR)
(72) Inventor: YUN, Jin Chan, 16677 Suwon-si (KR); KIM, Da Hye, 16677 Suwon-si (KR); PARK, Jae Hyun, 16677 Suwon-si (KR); HUH, Dai Hong, 16677 Suwon-si (KR)
(74) Representative: Marks & Clerk LLP

(57) **Abstract**

A semiconductor device includes a lower interlayer insulating layer, an insulating pattern extending in a first horizontal direction, a first plurality of lower nanosheets and a second plurality of lower nanosheets, a first plurality of middle nanosheets and a second plurality of middle nanosheets, a first plurality of upper nanosheets and a second plurality of upper nanosheets. The semiconductor device includes a first stack separation layer, a second stack separation layer, a first gate electrode, a second gate electrode, a first middle source/drain region, a second middle source/drain region, and a middle source/drain contact. The middle source/drain contact is electrically connected to the first and second middle source/drain regions and penetrates the lower interlayer insulating layer and the insulating pattern in a vertical direction. An upper surface of the middle source/drain contact is formed lower than a bottom surface of a lowermost nanosheet of the first plurality of upper nanosheets.

## Description

### BACKGROUND

As a scaling technique for increasing the density of integrated circuit devices, the concept of a multi-gate transistor has been proposed in which a silicon body in the form of a fin or nanowire is formed on a substrate and a gate is formed on the surface of the silicon body.

The multi-gate transistor takes advantage of its three-dimensional (3D) channel, allowing for easy scaling both up and down. Additionally, the multi-gate transistor offers improved control over the current without the need to increase the gate length. Furthermore, the multi-gate transistor effectively mitigates the short channel effect (SCE), which is the phenomenon where the electric potential of a channel region is affected by the drain voltage.

### SUMMARY

The present disclosure relates to a semiconductor device, and more particularly, to a semiconductor device including multi-bridge channel field-effect transistors (MBCFETs^{™}). Aspects of the present disclosure provide a static random-access memory (SRAM) semiconductor device with an improved integration density.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

According to an aspect of the present disclosure, there is provided a semiconductor device, comprising a lower interlayer insulating layer, an insulating pattern extending in a first horizontal direction on an upper surface of the lower interlayer insulating layer, a first plurality of lower nanosheets and a second plurality of lower nanosheets spaced apart from each other in the first horizontal direction on the insulating pattern, a first plurality of middle nanosheets and a second plurality of middle nanosheets spaced apart from each other in the first horizontal direction, on the first plurality of lower nanosheets and the second plurality of lower nanosheets, respectively, a first plurality of upper nanosheets and a second plurality of upper nanosheets spaced apart from each other in the first horizontal direction, on the first plurality of middle nanosheets and the second plurality of middle nanosheets, respectively, a first stack separation layer disposed between the first plurality of lower nanosheets and the first plurality of middle nanosheets and between the second plurality of lower nanosheets and the second plurality of middle nanosheets, a second stack separation layer disposed between the first plurality of middle nanosheets and the first plurality of upper nanosheets and between the second plurality of middle nanosheets and the second plurality of upper nanosheets, a first gate electrode extending in a second horizontal direction different from the first horizontal direction on the insulating pattern, the first gate electrode surrounding the first plurality of lower nanosheets, the first plurality of middle nanosheets and the first plurality of upper nanosheets, a second gate electrode extending in the second horizontal direction on the insulating pattern, the second gate electrode spaced apart from the first gate electrode in the first horizontal direction, the second gate electrode surrounding the second plurality of lower nanosheets, the second plurality of middle nanosheets and the second plurality of upper nanosheets, a first middle source/drain region contacting both sidewalls in the first horizontal direction of the first plurality of middle nanosheets, a second middle source/drain region contacting both sidewalls in the first horizontal direction of the second plurality of middle nanosheets, and a middle source/drain contact disposed between the first middle source/drain region and the second middle source/drain region, the middle source/drain contact electrically connected to the first and second middle source/drain regions, the middle source/drain contact penetrating the lower interlayer insulating layer and the insulating pattern in a vertical direction, wherein an upper surface of the middle source/drain contact is formed lower than a bottom surface of a lowermost nanosheet of the first plurality of upper nanosheets.

In some embodiments, the first and second lower source/drain regions are formed in a P-type metal-oxide semiconductor region, and the first and second middle source/drain regions are formed in an N-type metal-oxide semiconductor region. In this case, the lower source/drain regions may comprise P-doped material and the middle source/drain regions may comprise N-doped material.

A semiconductor device comprising: an insulating layer; an insulating pattern extending in a first horizontal direction on an upper surface of the insulating layer; a first plurality of lower nanosheets and a second plurality of lower nanosheets spaced apart from each other in the first horizontal direction on the insulating pattern; a first plurality of middle nanosheets and a second plurality of middle nanosheets spaced apart from each other in the first horizontal direction, wherein the first plurality of middle nanosheets and the second plurality of middle nanosheets are arranged on the first plurality of lower nanosheets and the second plurality of lower nanosheets, respectively; a first plurality of upper nanosheets and a second plurality of upper nanosheets spaced apart from each other in the first horizontal direction, wherein the first plurality of upper nanosheets and the second plurality of upper nanosheets are arranged on the first plurality of middle nanosheets and the second plurality of middle nanosheets, respectively; a first stack separation layer disposed between the first plurality of lower nanosheets and the first plurality of middle nanosheets and between the second plurality of lower nanosheets and the second plurality of middle nanosheets; a second stack separation layer disposed between the first plurality of middle nanosheets and the first plurality of upper nanosheets and between the second plurality of middle nanosheets and the second plurality of upper nanosheets; a first gate electrode extending on the insulating pattern in a second horizontal direction different from the first horizontal direction, wherein the first gate electrode surrounds the first plurality of lower nanosheets, the first plurality of middle nanosheets, and the first plurality of upper nanosheets; a second gate electrode extending on the insulating pattern in the second horizontal direction, wherein the second gate electrode is spaced apart from the first gate electrode in the first horizontal direction, and the second gate electrode surrounds the second plurality of lower nanosheets, the second plurality of middle nanosheets and the second plurality of upper nanosheets; a first middle source/drain region contacting both sidewalls of the first plurality of middle nanosheets in the first horizontal direction; a second middle source/drain region contacting both sidewalls of the second plurality of middle nanosheets in the first horizontal direction; and a middle source/drain contact disposed between the first middle source/drain region and the second middle source/drain region, wherein the middle source/drain contact is electrically connected to the first and second middle source/drain regions, and the middle source/drain contact penetrates the insulating layer and the insulating pattern in a vertical direction, wherein an upper surface of the middle source/drain contact is formed lower than a bottom surface of a lowermost nanosheet of the first plurality of upper nanosheets.

According to an aspect of the present disclosure, there is provided a semiconductor device, comprising a first plurality of lower nanosheets and a second plurality of lower nanosheets spaced apart from each other in a first horizontal direction, a first plurality of middle nanosheets and a second plurality of middle nanosheets spaced apart from each other in the first horizontal direction, on the first plurality of lower nanosheets and the second plurality of lower nanosheets, respectively, a first plurality of upper nanosheets and a second plurality of upper nanosheets spaced apart from each other in the first horizontal direction, on the first plurality of middle nanosheets and the second plurality of middle nanosheets, respectively, a first stack separation layer disposed between the first plurality of lower nanosheets and the first plurality of middle nanosheets and between the second plurality of lower nanosheets and the second plurality of middle nanosheets, a second stack separation layer disposed between the first plurality of middle nanosheets and the first plurality of upper nanosheets and between the second plurality of middle nanosheets and the second plurality of upper nanosheets, a first gate electrode extending in a second horizontal direction different from the first horizontal direction, the first gate electrode surrounding the first plurality of lower nanosheets, the first plurality of middle nanosheets and the first plurality of upper nanosheets, a second gate electrode extending in the second horizontal direction, the second gate electrode spaced apart from the first gate electrode in the first horizontal direction, the second gate electrode surrounding the second plurality of lower nanosheets, the second plurality of middle nanosheets and the second plurality of upper nanosheets, a first middle source/drain region contacting both sidewalls of the first plurality of middle nanosheets in the first horizontal direction, a second middle source/drain region contacting both sidewalls of the second plurality of middle nanosheets in the first horizontal direction, a first insulating layer extending in the second horizontal direction between the first plurality of lower nanosheets and the second plurality of lower nanosheets, and a middle source/drain contact including a first portion disposed on an upper surface of the first insulating layer between the first and second middle source/drain regions, and a second portion connected to the first portion by penetrating the first insulating layer in a vertical direction, the first portion electrically connected to the first and second middle source/drain regions, wherein a width of the first portion of the middle source/drain contact in the first horizontal direction is greater than a width of the second portion of the middle source/drain contact in the first horizontal direction.

According to an aspect of the present disclosure, there is provided a semiconductor device, comprising a lower interlayer insulating layer, an insulating pattern extending in a first horizontal direction on an upper surface of the lower interlayer insulating layer, a first plurality of lower nanosheets and a second plurality of lower nanosheets spaced apart from each other in the first horizontal direction on the insulating pattern, a first plurality of middle nanosheets and a second plurality of middle nanosheets spaced apart from each other in the first horizontal direction, on the first plurality of lower nanosheets and the second plurality of lower nanosheets, respectively, a first plurality of upper nanosheets and a second plurality of upper nanosheets spaced apart from each other in the first horizontal direction, on the first plurality of middle nanosheets and the second plurality of middle nanosheets, respectively, a first stack separation layer disposed between the first plurality of lower nanosheets and the first plurality of middle nanosheets and between the second plurality of lower nanosheets and the second plurality of middle nanosheets, a second stack separation layer disposed between the first plurality of middle nanosheets and the first plurality of upper nanosheets and between the second plurality of middle nanosheets and the second plurality of upper nanosheets, a first gate electrode extending in a second horizontal direction different from the first horizontal direction on the insulating pattern, the first gate electrode surrounding the first plurality of lower nanosheets, the first plurality of middle nanosheets and the first plurality of upper nanosheets, a second gate electrode extending in the second horizontal direction on the insulating pattern, the second gate electrode spaced apart from the first gate electrode in the first horizontal direction, the second gate electrode surrounding the second plurality of lower nanosheets, the second plurality of middle nanosheets and the second plurality of upper nanosheets, a first lower source/drain region contacting both sidewalls in the first horizontal direction of the first plurality of lower nanosheets in the first horizontal direction, a second lower source/drain region contacting both sidewalls of the second plurality of lower nanosheets in the first horizontal direction, a first middle source/drain region contacting both sidewalls of the first plurality of middle nanosheets in the first horizontal direction, a second middle source/drain region contacting both sidewalls of the second plurality of middle nanosheets in the first horizontal direction, a first upper source/drain region contacting both sidewalls of the first plurality of upper nanosheets in the first horizontal direction, a second upper source/drain region contacting both sidewalls of the second plurality of upper nanosheets in the first horizontal direction, a first insulating layer extending in the second horizontal direction between the first and second lower source/drain regions, a second insulating layer extending in the second horizontal direction between the first and second upper source/drain regions, a third insulating layer extending in the second horizontal direction between the first and second insulating layers, the third insulating layer including a material different from a material of each of the first and second insulating layers, and a middle source/drain contact including a first portion disposed within the third insulating layer between the first and second middle source/drain regions, and a second portion connected to the first portion by penetrating the first insulating layer in a vertical direction, the first portion electrically connected to the first and second middle source/drain regions, wherein a width of the first portion of the middle source/drain contact in the first horizontal direction is greater than a width of the second portion of the middle source/drain contact in the first horizontal direction.

It should be noted that the effects of the present disclosure are not limited to those described above, and other effects of the present disclosure will be apparent from the following description.

At least some of the above and other features of the invention are set out in the claims.

### BRIEF DESCRIPTION OF THE DRAWINGS

The above and other aspects and features of the present disclosure will become more apparent by describing implementations thereof with reference to the attached drawings, in which:
FIG. 1 is a layout view of a semiconductor device according to some implementations;
FIG. 2 is a cross-sectional view taken along line A-A' of FIG. 1;
FIG. 3 is a cross-sectional view taken along line B-B' of FIG. 1;
FIG. 4 is a cross-sectional view taken along line C-C' of FIG. 1;
FIG. 5 is a cross-sectional view taken along line D-D' of FIG. 1;
FIG. 6 is a cross-sectional view taken along line E-E' of FIG. 1;
FIGS. 7 through 53 are cross-sectional views illustrating intermediate steps of a method of fabricating a semiconductor device according to some implementations;
FIG. 54 is a cross-sectional view of a semiconductor device according to some implementations;
FIGS. 55 and 56 are cross-sectional views of a semiconductor device according to some implementations;
FIGS. 57 through 59 are cross-sectional views of a semiconductor device according to some implementations; and
FIGS. 60 and 61 are cross-sectional views of a semiconductor device according to some implementations.

### DETAILED DESCRIPTION

Semiconductor devices according to some implementations are illustrated in the accompanying drawings as including multi-bridge channel field-effect transistors (MBCFETs^{™}) with nanosheets, but the present disclosure is not limited thereto. In some implementations, the semiconductor devices may include fin-type field-effect transistors (FinFETs) with fin-shaped pattern channel regions, tunneling field-effect transistors (FETs), or three-dimensional (3D) transistors. Furthermore, in some implementations, the semiconductor devices may include bipolar junction transistors or lateral double-diffused metal-oxide semiconductor (LDMOS) transistors. For example, the semiconductor devices according to some implementations may be static random-access memory (SRAM) semiconductor devices that include two P-type metal-oxide semiconductor (PMOS) transistors and four N-type metal-oxide semiconductor (NMOS) transistors.

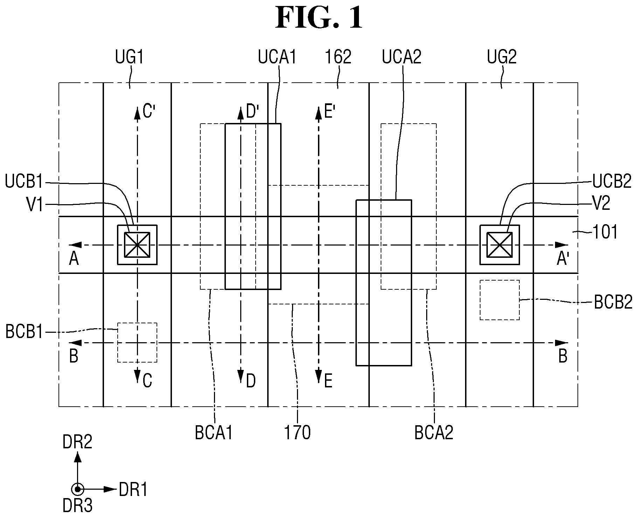

A semiconductor device according to some implementations will hereinafter be described with reference to FIGS. 1 through 6.

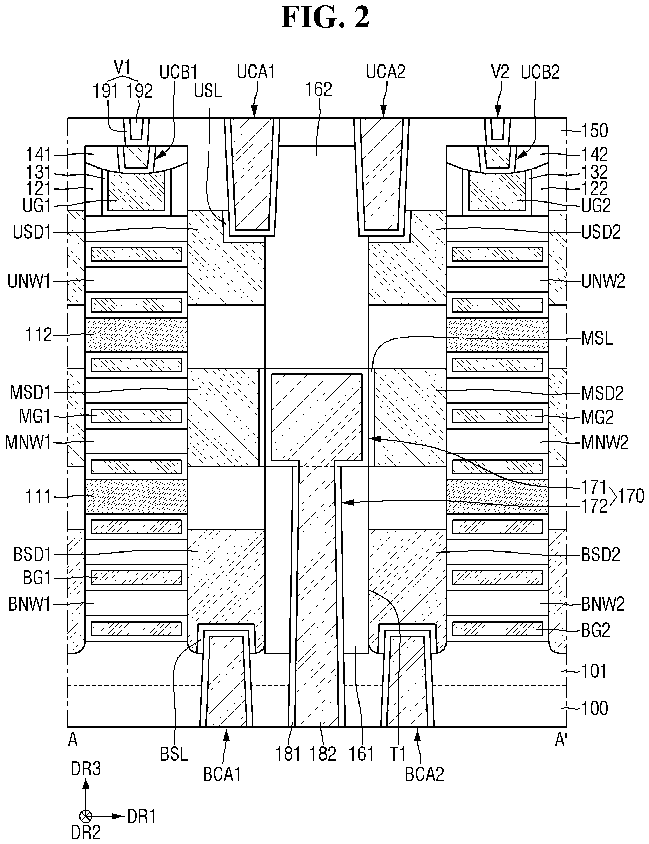

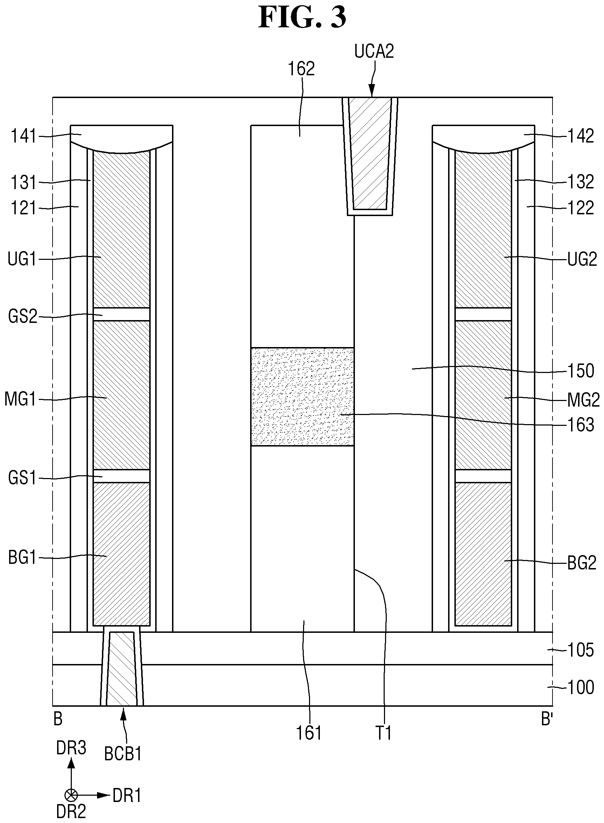

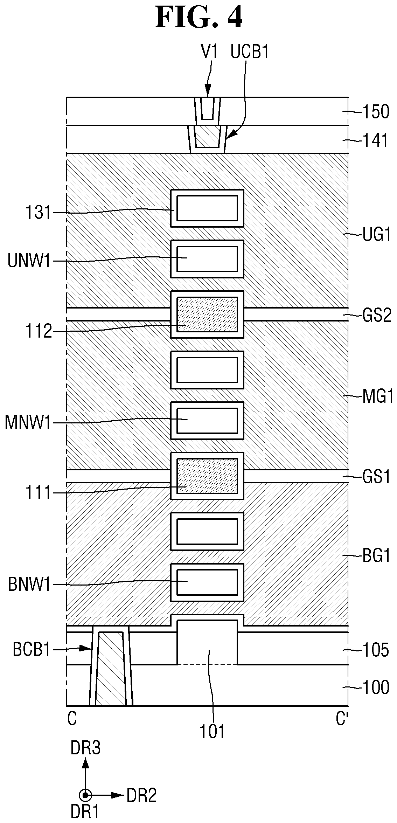

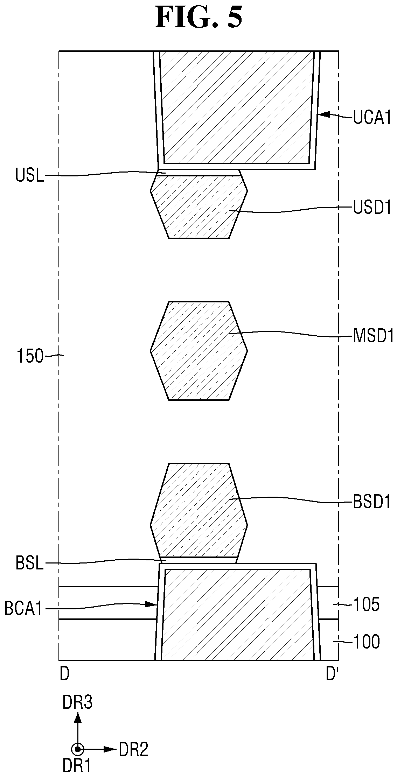

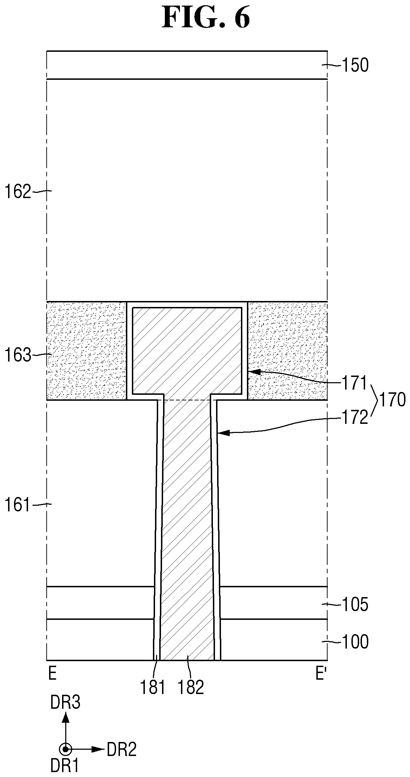

FIG. 1 is a layout view of a semiconductor device according to some implementations. FIG. 2 is a cross-sectional view taken along line A-A' of FIG. 1. FIG. 3 is a cross-sectional view taken along line B-B' of FIG. 1. FIG. 4 is a cross-sectional view taken along line C-C' of FIG. 1. FIG. 5 is a cross-sectional view taken along line D-D' of FIG. 1. FIG. 6 is a cross-sectional view taken along line E-E' of FIG. 1.

Referring to FIGS. 1 through 6, the semiconductor device according to some implementations includes a lower interlayer insulating layer 100, an insulating pattern 101, a field insulating layer 105, a first plurality of lower nanosheets BNW1, a second plurality of lower nanosheets BNW2, a first plurality of middle nanosheets MNW1, a second plurality of middle nanosheets MNW2, a first plurality of upper nanosheets UNW1, a second plurality of upper nanosheets UNW2, first and second stack separation layers 111 and 112, first and second lower gate electrodes BG1 and BG2, first and second middle gate electrodes MG1 and MG2, first and second upper gate electrodes UG1 and UG2, first and second gate separation layers GS1 and GS2, first and second gate spacers 121 and 122, first and second gate insulating layers 131 and 132, first and second capping patterns 141 and 142, first and second lower source/drain regions BSD1 and BSD2, first and second middle source/drain regions MSD1 and MSD2, first and second upper source/drain regions USD1 and USD2, an upper interlayer insulating layer 150, first, second, and third insulating layers 161, 162, and 163, a middle source/drain contact 170, first and second lower source/drain contacts BCA1 and BCA2, first and second upper source/drain contacts UCA1 and UCA2, a lower silicide layer BSL, a middle silicide layer MSL, an upper silicide layer USL, first and second lower gate contacts BCB1 and BCB2, first and second upper gate contacts UCB1 and UCB2, and first and second vias V1 and V2.

The lower interlayer insulating layer 100 may include at least one of, for example, silicon oxide, silicon nitride, silicon oxynitride, and a low-k material. The low-k material may be, for example, fluorinated tetraethyl orthosilicate (FTEOS), hydrogen silsesquioxane (HSQ), bis-benzocyclobutene (BCB), tetramethyl orthosilicate (TMOS), octamethylcyclotetrasiloxane (OMCTS), hexamethyldisiloxane (HMDS), trimethylsilyl borate (TMSB), diacetoxy ditertiary butoxy siloxane (DADBS), trimethylsilil phosphate (TMSP), polytetrafluoroethylene (PTFE), tonen silazen (TOSZ), fluoride silicate glass (FSG), polyimide nanofoam such as polypropylene oxide, carbon doped silicon oxide (CDO), organo silicate glass (OSG), SiLK, amorphous fluorinated carbon, silica aerogel, silica xerogel, mesoporous silica, or a combination thereof, but the present disclosure is not limited thereto.

First and second horizontal directions DR1 and DR2 may be defined as directions parallel to the upper surface of the lower interlayer insulating layer 100. The second horizontal direction DR2 may be defined as a different direction from the first horizontal direction DR1. A vertical direction DR3 is defined as a direction perpendicular to both the first and second horizontal directions DR1 and DR2. That is, the vertical direction DR3 is defined as a direction perpendicular to the upper surface of the lower interlayer insulating layer 100.

The insulating pattern 101 may extend in the first horizontal direction DR1 on the upper surface of the lower interlayer insulating layer 100. The insulating pattern 101 may protrude in the vertical direction DR3 from the upper surface of the lower interlayer insulating layer 100. The insulating pattern 101 may include an insulating material. For example, the insulating pattern 101 may include the same material as the lower interlayer insulating layer 100.

The field insulating layer 105 may be disposed on the upper surface of the lower interlayer insulating layer 100. The field insulating layer 105 may surround the sidewalls of the insulating pattern 101. For example, the upper surface of the insulating pattern 101 may protrude in the vertical direction DR3 beyond the upper surface of the field insulating layer 105, but the present disclosure is not limited thereto. In some implementations, the upper surface of the insulating pattern 101 may be formed on the same plane as the upper surface of the field insulating layer 105. The field insulating layer 105 may include, for example, an oxide film, a nitride film, an oxynitride film, or a combination thereof.

The first plurality of lower nanosheets BNW1 and the second plurality of lower nanosheets BNW2 may be disposed on the insulating pattern 101. The second plurality of lower nanosheets BNW2 may be spaced apart from the first plurality of lower nanosheets BNW1 in the first horizontal direction DR1. The first plurality of lower nanosheets BNW1 and second plurality of lower nanosheets BNW2 may include stacks of multiple nanosheets that are spaced apart in the vertical direction DR3. For example, the first plurality of lower nanosheets BNW1 and the second plurality of lower nanosheets BNW2 may include stacks of two nanosheets that are spaced apart in the vertical direction DR3, but the present disclosure is not limited thereto. Alternatively, the first plurality of lower nanosheets BNW1 and the second plurality of lower nanosheets BNW2 may include stacks of three or more nanosheets that are spaced apart in the vertical direction DR3. For example, the first plurality of lower nanosheets BNW1 may be disposed at the same level as the corresponding second plurality of lower nanosheets BNW2.

The first plurality of middle nanosheets MNW1 may be disposed on the first plurality of lower nanosheets BNW1. The first plurality of middle nanosheets MNW1 may be spaced apart from the first plurality of lower nanosheets BNW1 in the vertical direction DR3. The second plurality of middle nanosheets MNW2 may be disposed on the second plurality of lower nanosheets BNW2. The second plurality of middle nanosheets MNW2 may be spaced apart from the second plurality of lower nanosheets BNW2 in the vertical direction DR3. The second plurality of middle nanosheets MNW2 may be spaced apart from the first plurality of middle nanosheets MNW1 in the first horizontal direction DR1.

The first plurality of middle nanosheets MNW1 and the second plurality of middle nanosheets MNW2 may include stacks of multiple nanosheets that are spaced apart in the vertical direction DR3. For example, the first plurality of middle nanosheets MNW1 and the second plurality of middle nanosheets MNW2 may include stacks of two nanosheets that are spaced apart in the vertical direction DR3, but the present disclosure is not limited thereto. Alternatively, the first plurality of middle nanosheets MNW1 and the second plurality of middle nanosheets MNW2 may include stacks of three or more nanosheets that are spaced apart in the vertical direction DR3. For example, the first plurality of middle nanosheets MNW1 may be disposed at the same level as their corresponding second plurality of middle nanosheets MNW2.

The first plurality of upper nanosheets UNW1 may be disposed on the first plurality of middle nanosheets MNW1. The first plurality of upper nanosheets UNW1 may be spaced apart from the first plurality of middle nanosheets MNW1 in the vertical direction DR3. The second plurality of upper nanosheets UNW2 may be disposed on the second plurality of middle nanosheets MNW2. The second plurality of upper nanosheets UNW2 may be spaced apart from the second plurality of middle nanosheets MNW2 in the vertical direction DR3. The second plurality of upper nanosheets UNW2 may be spaced apart from the first plurality of upper nanosheets UNW1 in the first horizontal direction DR1.

The first plurality of upper nanosheets UNW1 and the second plurality of upper nanosheets UNW2 may include stacks of multiple nanosheets that are spaced apart in the vertical direction DR3. For example, the first plurality of upper nanosheets UNW1 and the second plurality of upper nanosheets UNW2 may include stacks of two nanosheets that are spaced apart in the vertical direction DR3, but the present disclosure is not limited thereto. Alternatively, the first plurality of upper nanosheets UNW1 and the second plurality of upper nanosheets UNW2 may include stacks of three or more nanosheets that are spaced apart in the vertical direction DR3. For example, the first plurality of upper nanosheets UNW1 may be disposed at the same level as their corresponding second plurality of upper nanosheets UNW2.

In some implementations, the first plurality of lower nanosheets BNW1, the second plurality of lower nanosheets BNW2, the first plurality of middle nanosheets MNW1, the second plurality of middle nanosheets MNW2, the first plurality of upper nanosheets UNW1, and the second plurality of upper nanosheets UNW2 may include silicon (Si), but the present disclosure is not limited thereto. Alternatively, the first plurality of lower nanosheets BNW1, the second plurality of lower nanosheets BNW2, the first plurality of middle nanosheets MNW1, the second plurality of middle nanosheets MNW2, the first plurality of upper nanosheets UNW1, and the second plurality of upper nanosheets UNW2 may include silicon-germanium (SiGe).

The first stack separation layer 111 may be disposed between the first plurality of lower nanosheets BNW1 and the first plurality of middle nanosheets MNW1. That is, the first stack separation layer 111 may be disposed between the uppermost nanosheet of the first plurality of lower nanosheets BNW1 and the lowermost nanosheet of the first plurality of middle nanosheets MNW1. For example, the first stack separation layer 111 may be spaced apart in the vertical direction DR3 from both the uppermost nanosheet of the first plurality of lower nanosheets BNW1 and the lowermost nanosheet of the first plurality of middle nanosheets MNW 1.

Additionally, the first stack separation layer 111 may be disposed between the second plurality of lower nanosheets BNW2 and the second plurality of middle nanosheets MNW2. That is, the first stack separation layer 111 may be disposed between the uppermost nanosheet of the second plurality of lower nanosheets BNW2 and the lowermost nanosheet of the second plurality of middle nanosheets MNW2. For example, the first stack separation layer 111 may be spaced apart in the vertical direction DR3 from both the uppermost nanosheet of the second plurality of lower nanosheets BNW2 and the lowermost nanosheet of the second plurality of middle nanosheets MNW2. For example, part of the first stack separation layer 111 disposed between the second plurality of lower nanosheets BNW2 and the second plurality of middle nanosheets MNW2 may be spaced apart in the first horizontal direction DR1 from part of the first stack separation layer 111 disposed between the first plurality of lower nanosheets BNW1 and the first plurality of middle nanosheets MNW1.

The second stack separation layer 112 may be disposed between the first plurality of middle nanosheets MNW1 and the first plurality of upper nanosheets UNW1. That is, the second stack separation layer 112 may be disposed between the uppermost nanosheet of the first plurality of lower nanosheets MNW1 and the lowermost nanosheet of the first plurality of upper nanosheets UNW1. For example, the second stack separation layer 112 may be spaced apart in the vertical direction DR3 from both the uppermost nanosheet of the first plurality of lower nanosheets MNW1 and the lowermost nanosheet of the first plurality of upper nanosheets UNW1.

Additionally, the second stack separation layer 112 may be disposed between the second plurality of middle nanosheets MNW2 and the second plurality of upper nanosheets UNW2. That is, the second stack separation layer 112 may be disposed between the uppermost nanosheet of the second plurality of lower nanosheets MNW2 and the lowermost nanosheet of the second plurality of upper nanosheets UNW2. For example, the second stack separation layer 112 may be spaced apart in the vertical direction DR3 from both the uppermost nanosheet of the second plurality of lower nanosheets MNW2 and the lowermost nanosheet of the second plurality of upper nanosheets UNW2. For instance, part of the second stack separation layer 112 disposed between the second plurality of middle nanosheets MNW2 and the second plurality of upper nanosheets UNW2 may be spaced apart in the first horizontal direction DR1 from part of the second stack separation layer 112 disposed between the first plurality of middle nanosheets MNW1 and the first plurality of upper nanosheets UNW1.

The first and second stack separation layers 111 and 112 may include an insulating material. For example, the first and second stack separation layers 111 and 112 may include at least one of silicon nitride (SiN), silicon oxycarbonitride (SiOCN), silicoboron carbonitride (SiBCN), silicon carbonitride (SiCN), silicon oxynitride (SiON), or a combination thereof, but the present disclosure is not limited thereto.

A first gate electrode (BG1, MG1, and UG1) may extend in the second horizontal direction DR2 over the insulating pattern 101 and the field insulating layer 105. The first gate electrode (BG1, MG1, and UG1) may include the first lower gate electrode BG1, the first middle gate electrode MG1, and the first upper gate electrode UG1. The first gate electrode (BG1, MG1, and UG1) may surround the first plurality of lower nanosheets BNW1, the first stack separation layer 111, the first plurality of middle nanosheets MNW1, the second stack separation layer 112, and the first plurality of upper nanosheets UNW1.

The first lower gate electrode BG1 may be disposed on the insulating pattern 101 and the field insulating layer 105. The first middle gate electrode MG1 may be disposed on the first lower gate electrode BG1. For example, the first middle gate electrode MG1 may be spaced apart from the first lower gate electrode BG1 in the vertical direction DR3. The first upper gate electrode UG1 may be disposed on the first middle gate electrode MG1. For example, the first upper gate electrode UG1 may be spaced apart from the first middle gate electrode MG1 in the vertical direction DR3.

In some implementations, the first lower gate electrode BG1 may surround parts of the first plurality of lower nanosheets BNW1 and first stack separation layer 111. The first middle gate electrode MG1 may surround other parts of the first stack separation layer 111 and parts of the first plurality of middle nanosheets MNW1 and second stack separation layer 112. The first upper gate electrode UG1 may surround other parts of the second stack separation layer 112 and the first plurality of upper nanosheets UNW1.

In some implementations, the first lower gate electrode BG1 may be formed in a PMOS region. That is, the transistor including the first lower gate electrode BG1 may be a PMOS transistor. Similarly, the first middle gate electrode MG1 and the first upper gate electrode UG1 may both be formed in an NMOS region. That is, the transistor including the first middle gate electrode MG1 and the transistor including the first upper gate electrode UG1 may both be NMOS transistors.

A second gate electrode (BG2, MG2, and UG2) may extend in the second horizontal direction DR2 over the insulating pattern 101 and the field insulating layer 105. The second gate electrode (BG2, MG2, and UG2) may be spaced apart from the first gate electrode (BG1, MG1, and UG1) in the first horizontal direction DR1. The second gate electrode (BG2, MG2, and UG2) may include the second lower gate electrode BG2, the second middle gate electrode MG2, and the second upper gate electrode UG2. The second gate electrode (BG2, MG2, and UG2) may surround the second plurality of lower nanosheets BNW2, the first stack separation layer 111, the second plurality of middle nanosheets MNW2, the second stack separation layer 112, and the second plurality of upper nanosheets UNW2.

The second lower gate electrode BG2 may be disposed on the insulating pattern 101 and the field insulating layer 105. The second middle gate electrode MG2 may be disposed on the second lower gate electrode BG2. For example, the second middle gate electrode MG2 may be spaced apart from the second lower gate electrode BG2 in the vertical direction DR3. The second upper gate electrode UG2 may be disposed on the second middle gate electrode MG2. For example, the second upper gate electrode UG2 may be spaced apart from the second middle gate electrode MG2 in the vertical direction DR3.

In some implementations, the second lower gate electrode BG2 may surround parts of the second plurality of lower nanosheets BNW2 and first stack separation layer 111. The second middle gate electrode MG2 may surround other parts of the first stack separation layer 111 and parts of the second plurality of middle nanosheets MNW2 and second stack separation layer 112. The second upper gate electrode UG2 may surround other parts of the second stack separation layer 112 and the second plurality of upper nanosheets UNW2.

In some implementations, the second lower gate electrode BG2 may be formed in the PMOS region. That is, the transistor including the second lower gate electrode BG2 may be a PMOS transistor. Similarly, the second middle gate electrode MG2 and the second upper gate electrode UG2 may both be formed in the NMOS region. That is, the transistor including the second middle gate electrode MG2 and the transistor including the second upper gate electrode UG2 may both be NMOS transistors.

The first lower gate electrode BG1, the first middle gate electrode MG1, the first upper gate electrode UG1, the second lower gate electrode BG2, the second middle gate electrode MG2, and the second upper gate electrode UG2 may include, for example, titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel-platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof. The first lower gate electrode BG1, the first middle gate electrode MG1, the first upper gate electrode UG1, the second lower gate electrode BG2, the second middle gate electrode MG2, and the second upper gate electrode UG2 may include a conductive metal oxide or conductive metal oxynitride, and may also include an oxidized form of any one of the aforementioned materials.

The first gate separation layer GS1 may be disposed between the first lower gate electrode BG1 and the first middle gate electrode MG1. The first gate separation layer GS 1 may separate the first lower gate electrode BG1 and the first middle gate electrode MG1 in the vertical direction DR3. The first gate separation layer GS1 may contact both the first lower gate electrode BG1 and the first middle gate electrode MG1. Additionally, the first gate separation layer GS1 may be disposed between the second lower gate electrode BG2 and the second middle gate electrode MG2. The first gate separation layer GS1 may separate the second lower gate electrode BG2 and the second middle gate electrode MG2 in the vertical direction DR3. The first gate separation layer GS1 may contact both the second lower gate electrode BG2 and the second middle gate electrode MG2. For example, part of the first gate separation layer GS1 disposed between the second lower gate electrode BG2 and the second middle gate electrode MG2 may be spaced apart in the first horizontal direction DR1 from part of the first gate separation layer GS1 disposed between the first lower gate electrode BG1 and the first middle gate electrode MG1.

The second gate separation layer GS2 may be disposed between the first middle gate electrode MG1 and the first upper gate electrode UG1. The second gate separation layer GS2 may separate the first middle gate electrode MG1 and the first upper gate electrode UG1 in the vertical direction DR3. The second gate separation layer GS2 may contact both the first middle gate electrode MG1 and the first upper gate electrode UG1. Additionally, the second gate separation layer GS2 may be disposed between the second middle gate electrode MG2 and the second upper gate electrode UG2. The second gate separation layer GS2 may separate the second middle gate electrode MG2 and the second upper gate electrode UG2 in the vertical direction DR3. The second gate separation layer GS2 may contact both the second middle gate electrode MG2 and the second upper gate electrode UG2. For example, part of the second gate separation layer GS2 disposed between the second middle gate electrode MG2 and the second upper gate electrode UG2 may be spaced apart in the first horizontal direction DR1 from part of the second gate separation layer GS2 disposed between the first middle gate electrode MG1 and the first upper gate electrode UG1.

The first and second gate separation layers GS1 and GS2 may include an insulating material. For example, the first and second gate separation layers GS1 and GS2 may include at least one of SiN, SiOCN, SiBCN, SiCN, SiON, or a combination thereof, but the present disclosure is not limited thereto.

The first lower source/drain region BSD1 may be disposed on both sidewalls of the first lower gate electrode BG1 in the first horizontal direction DR1 on the insulating pattern 101. The first lower source/drain region BSD1 may contact both sidewalls of the first plurality of lower nanosheets BNW1 in the first horizontal direction DR1. The first middle source/drain region MSD1 may be disposed on both sidewalls of the first middle gate electrode MG1 in the first horizontal direction DR1 on the first lower source/drain region BSD1. The first middle source/drain region MSD1 may be spaced apart from the first lower source/drain region BSD1 in the vertical direction DR3. The first middle source/drain region MSD1 may contact both sidewalls of the first plurality of middle nanosheets MNW1 in the first horizontal direction DR1. The first upper source/drain region USD1 may be disposed on both sidewalls of the first upper gate electrode UG1 in the first horizontal direction DR1 on the first middle source/drain region MSD1. The first upper source/drain region USD1 may be spaced apart from the first middle source/drain region MSD1 in the vertical direction DR3. The first upper source/drain region USD1 may contact both sidewalls of the first plurality of upper nanosheets UNW1 in the first horizontal direction DR1.

In some implementations, the first lower source/drain region BSD1 may be formed in the PMOS region. Thus, the transistor including the first lower source/drain region BSD1 may be a PMOS transistor. Similarly, the first middle source/drain region MSD1 and the first upper source/drain region USD1 may both be formed in the NMOS region. Thus, the transistor including the first middle source/drain region MSD1 and the transistor including the first upper source/drain region USD1 may both be NMOS transistors.

The second lower source/drain region BSD2 may be disposed on both sidewalls of the second lower gate electrode BG2 in the first horizontal direction DR1 on the insulating pattern 101. The second lower source/drain region BSD2 may contact both sidewalls of the second plurality of lower nanosheets BNW2 in the first horizontal direction DR1. The second middle source/drain region MSD2 may be disposed on both sidewalls of the second middle gate electrode MG2 in the first horizontal direction DR1 on the second lower source/drain region BSD2. The second middle source/drain region MSD2 may be spaced apart from the second lower source/drain region BSD2 in the vertical direction DR3. The second middle source/drain region MSD2 may contact both sidewalls of the second plurality of middle nanosheets MNW2 in the first horizontal direction DR1. The second upper source/drain region USD2 may be disposed on both sidewalls of the second upper gate electrode UG2 in the first horizontal direction DR1 on the second middle source/drain region MSD2. The second upper source/drain region USD2 may be spaced apart from the second middle source/drain region MSD2 in the vertical direction DR3. The second upper source/drain region USD2 may contact both sidewalls of the second plurality of upper nanosheets UNW2 in the first horizontal direction DR1.

In some implementations, the second lower source/drain region BSD2 may be formed in the PMOS region. Thus, the transistor including the second lower source/drain region BSD2 may be a PMOS transistor. Similarly, the second middle source/drain region MSD2 and the second upper source/drain region USD2 may both be formed in the NMOS region. Thus, the transistor including the second middle source/drain region MSD2 and the transistor including the second upper source/drain region USD2 may both be NMOS transistors.

The first gate spacer 121 may extend in the second horizontal direction DR2 along both sidewalls of each of the first gate electrode (BG1, MG1, and UG1), the first gate separation layer GS1, and the second gate separation layer GS2, on both the uppermost nanosheet of the first plurality of upper nanosheets UNW1 and the field insulating layer 105. The second gate spacer 122 may extend in the second horizontal direction DR2 along both sidewalls of each of the second gate electrode (BG2, MG2, and UG2), the first gate separation layer GS1, and the second gate separation layer GS2, on both the uppermost nanosheet of the second plurality of upper nanosheets UNW2 and the field insulating layer 105.

The first and second gate spacers 121 and 122 may include at least one of SiN, SiON, silicon oxide (SiO₂), SiOCN, silicon boron nitride (SiBN), silicon oxyboron nitride (SiOBN), silicon oxycarbide (SiOC), and a combination thereof, but the present disclosure is not limited thereto.

The first gate insulating layer 131 may be disposed between the first gate electrode (BG1, MG1, and UG1) and the first gate spacer 121. The first gate insulating layer 131 may also be disposed between each of the first and second gate separation layers GS1 and GS2 and the first gate spacer 121. The first gate insulating layer 131 may also be disposed between the first lower gate electrode BG1 and the insulating pattern 101. The first gate insulating layer 131 may also be disposed between the first lower gate electrode BG1 and the field insulating layer 105. The first gate insulating layer 131 may also be disposed between the first lower gate electrode BG1 and the first plurality of lower nanosheets BNW1. The first gate insulating layer 131 may also be disposed between the first middle gate electrode MG1 and the first plurality of middle nanosheets MNW1. The first gate insulating layer 131 may also be disposed between the first upper gate electrode UG1 and the first plurality of upper nanosheets UNW1. The first gate insulating layer 131 may also be disposed between the first gate electrode (BG1, MG1, and UG1) and each of the first and second stack separation layers 111 and 112. The first gate insulating layer 131 may also be disposed between the first stack separation layer 111 and the first gate separation layer GS1. The first gate insulating layer 131 may also be disposed between the second stack separation layer 112 and the second gate separation layer GS2.

The second gate insulating layer 132 may be disposed between the second gate electrode (BG2, MG2, and UG2) and the second gate spacer 122. The second gate insulating layer 132 may also be disposed between each of the first and second gate separation layers GS1 and GS2 and the second gate spacer 122. The second gate insulating layer 132 may also be disposed between the second lower gate electrode BG2 and the insulating pattern 101. The second gate insulating layer 132 may also be disposed between the second lower gate electrode BG2 and the field insulating layer 105. The second gate insulating layer 132 may also be disposed between the second lower gate electrode BG2 and the second plurality of lower nanosheets BNW2. The second gate insulating layer 132 may also be disposed between the second middle gate electrode MG2 and the second plurality of middle nanosheets MNW2. The second gate insulating layer 132 may also be disposed between the second upper gate electrode UG2 and the second plurality of upper nanosheets UNW2. The second gate insulating layer 132 may also be disposed between the second gate electrode (BG2, MG2, and UG2) and each of the first and second stack separation layers 111 and 112.

In some implementations, the first gate insulating layer 131 may contact the first lower source/drain region BSD1, the first middle source/drain region MSD1, and the first upper source/drain region USD1, but the present disclosure is not limited thereto. Similarly, in some implementations, the second gate insulating layer 132 may contact the second lower source/drain region BSD2, the second middle source/drain region MSD2, and the second upper source/drain region USD2, but the present disclosure is not limited thereto.

In some implementations, an inner spacer may be disposed between the first gate insulating layer 131 and the first lower source/drain region BSD1 and/or between the first middle source/drain region MSD1 and the first upper source/drain region USD1. Similarly, an inner spacer may be disposed between the second gate insulating layer 132 and the second lower source/drain region BSD2 and/or between the second middle source/drain region MSD2 and the second upper source/drain region USD2. The inner spacers may include, for example, at least one of SiN, SiON, SiO₂, SiOCN, SiBN, SiOBN, SiOC, and a combination thereof.

The first and second gate insulating layers 131 and 132 may include at least one of silicon oxide, silicon oxynitride, silicon nitride, and a high-k material with a greater dielectric constant than silicon oxide. The high-k material may include, for example, at least one of hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate.

The semiconductor device according to some implementations may include negative capacitance (NC) FETs using negative capacitors. For example, each of the first and second gate insulating layers 131 and 132 may include a ferroelectric material film having ferroelectric properties and a paraelectric material film having paraelectric properties.

The ferroelectric material film may have a negative capacitance, and the paraelectric material film may have a positive capacitance. For example, if two or more capacitors are connected in series and have positive capacitance, the total capacitance of the two or more capacitors may be lower than the capacitance of each of the two or more capacitors. On the contrary, if at least one of the two or more capacitors has negative capacitance, the total capacitance of the two or more capacitors may have a positive value and may be greater than the absolute value of the capacitance of each of the two or more capacitors.

If the ferroelectric material film having a negative capacitance and the paraelectric material film having a positive capacitance are connected in series, the total capacitance of the ferroelectric material film and the paraelectric material film may increase. Accordingly, a transistor having the ferroelectric material film can have a sub-threshold swing (SS) of less than 60 mV/decade at room temperature.

The ferroelectric material film may have ferroelectric properties. The ferroelectric material film may include at least one of, for example, hafnium oxide, hafnium zirconium oxide, barium strontium titanium oxide, barium titanium oxide, and lead zirconium titanium oxide. For example, the hafnium zirconium oxide may be a material obtained by doping hafnium oxide with zirconium (Zr). In another example, the hafnium zirconium oxide may be a compound of hafnium (Hf), Zr, and oxygen (O).

The ferroelectric material film may further include a dopant. For example, the dopant may include at least one of Al, Ti, Nb, lanthanum (La), yttrium (Y), magnesium (Mg), Si, calcium (Ca), cerium (Ce), dysprosium (Dy), erbium (Er), gadolinium (Gd), Ge, scandium (Sc), strontium (Sr), and Sn. The type of dopant may vary depending on the type of material of the ferroelectric material film.

If the ferroelectric material film includes hafnium oxide, the dopant of the ferroelectric material film may include at least one of, for example, Gd, Si, Zr, Al, and Y.

If the dopant of the ferroelectric material film is Al, the ferroelectric material film may include about 3 atomic% (at%) to about 8 at% of Al. Here, the ratio of the dopant in the ferroelectric material film may refer to the ratio of the sum of the amounts of Hf and Al to the amount of Al in the ferroelectric material film.

If the dopant of the ferroelectric material film is Si, the ferroelectric material film may include about 2 at% to about 10 at% of Si. If the dopant of the ferroelectric material film is Y, the ferroelectric material film may include about 2 at% to about 10 at% of Y. If the dopant of the ferroelectric material film is Gd, the ferroelectric material film may include about 1 at% to about 7 at% of Gd. If the dopant of the ferroelectric material film is Zr, the ferroelectric material film may include about 50 at% to about 80 at% of Zr.

The paraelectric material film may include paraelectric properties. The paraelectric material film may include at least one of, for example, silicon oxide and a high-k metal oxide. The high-k metal oxide may include at least one of, for example, hafnium oxide, zirconium oxide, and aluminum oxide, but the present disclosure is not limited thereto.

The ferroelectric material film and the paraelectric material film may include the same material. The ferroelectric material film may have ferroelectric properties, but the paraelectric material film may not have ferroelectric properties. For example, if the ferroelectric material film and the paraelectric material film include hafnium oxide, the hafnium oxide included in the ferroelectric material film may have a different crystalline structure from the hafnium oxide included in the paraelectric material film.

The ferroelectric material film may be thick enough to exhibit ferroelectric properties. The ferroelectric material film may have a thickness of, for example, about 0.5 nm to about 10 nm, but the present disclosure is not limited thereto. A critical thickness that can exhibit ferroelectric properties may vary depending on the type of ferroelectric material, and thus, the thickness of the ferroelectric material film may vary depending on the type of ferroelectric material included in the ferroelectric material film.

For example, each of the first and second gate insulating layers 131 and 132 may include a ferroelectric material film. In another example, each of the first and second gate insulating layers 131 and 132 may include a plurality of ferroelectric material films that are spaced apart from each other. Each of the first and second gate insulating layers 131 and 132 may include a stack of a plurality of ferroelectric material films and a plurality of paraelectric material films that are alternately stacked with the ferroelectric material films.

The first capping pattern 141 may extend in the second horizontal direction DR2 over the upper surface of the first upper gate electrode UG1, the upper surface of the first gate spacer 121, and the uppermost surface of the first gate insulating layer 131. The second capping pattern 142 may extend in the second horizontal direction DR2 over the upper surface of the second upper gate electrode UG2, the upper surface of the second gate spacer 122, and the uppermost surface of the second gate insulating layer 132. Each of the first and second capping patterns 141 and 142 may include, for example, at least one of SiN, SiON, SiO₂, SiCN, SiOCN, and a combination thereof, but the present disclosure is not limited thereto.

The upper interlayer insulating layer 150 may be disposed on the field insulating layer 105. The upper interlayer insulating layer 150 may cover the first and second lower source/drain regions BSD1 and BSD2, the first and second middle source/drain regions MSD1 and MSD2, and the first and second upper source/drain regions USD1 and USD2. The upper interlayer insulating layer 150 may also surround the sidewalls of each of the first and second gate spacers 121 and 122. For example, the upper interlayer insulating layer 150 may contact both sidewalls of each of the first and second stack separation layers 111 and 112 in the first horizontal direction DR1.

In some implementations, the upper surface of the upper interlayer insulating layer 150 may be formed higher than the upper surfaces of the first and second capping patterns 141 and 142. That is, the upper interlayer insulating layer 150 may cover the upper surfaces of the first and second capping patterns 141 and 142, but the present disclosure is not limited thereto. Alternatively, the upper surface of the upper interlayer insulating layer 150 may be formed on the same plane as the upper surfaces of the first and second capping patterns 141 and 142. The upper interlayer insulating layer 150 may include, for example, at least one of silicon oxide, silicon nitride, silicon oxynitride, and a low-k material.

A first trench T1 may be formed in the upper interlayer insulating layer 150. The first trench T1 may extend in the second horizontal direction DR2 between the first gate electrode (BG1, MG1, and UG1) and the second gate electrode (BG2, MG2, and UG2). The first trench T1 may be formed between the first and second lower source/drain regions BSD1 and BSD2, between the first and second middle source/drain regions MSD1 and MSD2, and between the first and second upper source/drain regions USD1 and USD2.

For example, the bottom surface of the first trench T1 may be defined by both the insulating pattern 101 and the field insulating layer 105. The sidewalls, in the first horizontal direction DR1, of the first trench T1 may be defined by the upper interlayer insulating layer 150, the first and second lower source/drain regions BSD1 and BSD2, the first and second middle source/drain regions MSD1 and MSD2, and the first and second upper source/drain regions USD1 and USD2. The upper surface of the first trench T1 may be defined by the upper interlayer insulating layer 150.

The first insulating layer 161 may be disposed within the first trench T1. The first insulating layer 161 may extend in the second horizontal direction DR2 between the first and second lower source/drain regions BSD1 and BSD2. For example, the first insulating layer 161 may contact the sidewalls of each of the first and second lower source/drain regions BSD1 and BSD2. For example, the bottom surface of the first insulating layer 161 may contact both the insulating pattern 101 and the field insulating layer 105. The upper surface of the first insulating layer 161 may be formed on the same plane as the bottom surfaces of the first and second middle source/drain regions MSD1 and MSD2.

The second insulating layer 162 may be disposed on the upper surface of the first insulating layer 161 within the first trench T1. The second insulating layer 162 may be spaced apart in the vertical direction DR3 from the upper surface of the first insulating layer 161. The second insulating layer 162 may extend in the second horizontal direction DR2 between the first and second upper source/drain regions USD1 and USD2. For example, the second insulating layer 162 may contact the sidewalls of each of the first and second upper source/drain regions USD1 and USD2. The bottom surface of the second insulating layer 162 may be formed on the same plane as the upper surfaces of the first and second middle source/drain regions MSD1 and MSD2. The upper surface of the second insulating layer 162 may contact the upper interlayer insulating layer 150.

The first and second insulating layers 161 and 162 may include an insulating material. For example, the first and second insulating layers 161 and 162 may include a low-k material such as silicon oxide. For example, the first and second insulating layers 161 and 162 may include a material different from a material of the upper interlayer insulating layer 150, but the present disclosure is not limited thereto. Alternatively, the first and second insulating layers 161 and 162 may include the same material as the upper interlayer insulating layer 150.

The third insulating layer 163 may be disposed within the first trench T1, between the upper surface of the first insulating layer 161 and the bottom surface of the second insulating layer 162. The third insulating layer 163 may contact both the upper surface of the first insulating layer 161 and the bottom surface of the second insulating layer 162. The third insulating layer 163 may extend in the second horizontal direction DR2. The sidewalls, in the first horizontal direction DR1, of the third insulating layer 163 may contact the upper interlayer insulating layer 150. For example, the bottom surface of the third insulating layer 163 may be formed on the same plane as the bottom surfaces of the first and second middle source/drain regions MSD1 and MSD2. The upper surface of the third insulating layer 163 may be formed on the same plane as the upper surfaces of the first and second middle source/drain regions MSD1 and MSD2.

In some implementations, the third insulating layer 163 may include a material different from a material of each of the first insulating layer 161, the second insulating layer 162, and the upper interlayer insulating layer 150. Specifically, the third insulating layer 163 may include a material with a different etch selectivity from the first insulating layer 161, the second insulating layer 162, and the upper interlayer insulating layer 150. For example, the third insulating layer 163 may include one of SiN, SiON, SiCN, and SiOCN. Alternatively, the third insulating layer 163 may include a spin-on-hardmask (SOH).

The middle source/drain contact 170 may be disposed between the first and second lower source/drain regions BSD1 and BSD2. Additionally, the middle source/drain contact 170 may be disposed between the first and second middle source/drain regions MSD1 and MSD2. The middle source/drain contact 170 may extend to the bottom surface of the second insulating layer 162 by penetrating the lower interlayer insulating layer 100, the insulating pattern 101, the field insulating layer 105, the first insulating layer 161, and the third insulating layer 163 in the vertical direction DR3. The middle source/drain contact 170 may be electrically connected to the first and second middle source/drain regions MSD1 and MSD2. For example, the upper surface of the middle source/drain contact 170 may be formed lower than the bottom surfaces of the lowermost nanosheets of the first and second plurality of upper nanosheets UNW1 and UNW2.

The middle source/drain contact 170 may include a first portion 171 and a second portion 172, which is disposed below the first portion 171. The first portion 171 of the middle source/drain contact 170 may be disposed within the third insulating layer 163. The sidewalls, in the second horizontal direction DR2, of the first portion 171 may contact the third insulating layer 163. For example, at least part of the bottom surface of the first portion 171 of the middle source/drain contact 170 may contact the upper surface of the first insulating layer 161. The upper surface of the first portion 171 of the middle source/drain contact 170 may contact the bottom surface of the second insulating layer 162. For example, the bottom surface of the first portion 171 of the middle source/drain contact 170 may be formed on the same plane as the bottom surface of the third insulating layer 163. The upper surface of the first portion 171 of the middle source/drain contact 170 may be formed on the same plane as the upper surface of the third insulating layer 163.

The first portion 171 of the middle source/drain contact 170 may be disposed between the first and second middle source/drain regions MSD1 and MSD2. The first portion 171 of the middle source/drain contact 170 may be electrically connected to the first and second middle source/drain regions MSD1 and MSD2. For example, the bottom surface of the first portion 171 of the middle source/drain contact 170 may be formed on the same plane as the bottom surfaces of the first and second middle source/drain regions MSD1 and MSD2. The upper surface of the first portion 171 of the middle source/drain contact 170 may be formed on the same plane as the upper surfaces of the first and second middle source/drain regions MSD1 and MSD2. For example, the upper surface of the first portion 171 of the middle source/drain contact 170 may be formed lower than the bottom surfaces of the lowermost nanosheets of the first and second plurality of upper nanosheets UNW1 and UNW2.

The second portion 172 of the middle source/drain contact 170 may be connected to the bottom surface of the first portion 171 of the middle source/drain contact 170 by penetrating the lower interlayer insulating layer 100, the insulating pattern 101, the field insulating layer 105, and the first insulating layer 161 in the vertical direction DR3. The sidewalls of the second portion 172 of the middle source/drain contact 170 may be surrounded by the first insulating layer 161. Additionally, the sidewalls of the second portion 172 of the middle source/drain contact 170 may be surrounded by the lower interlayer insulating layer 100, the insulating pattern 101, and the field insulating layer 105.

The second portion 172 of the middle source/drain contact 170 may be disposed between the first and second lower source/drain regions BSD1 and BSD2. The second portion 172 of the middle source/drain contact 170 may be spaced apart from the first and second lower source/drain regions BSD1 and BSD2 in the first horizontal direction DR1. That is, the second portion 172 of the middle source/drain contact 170 may be insulated from the first and second lower source/drain regions BSD1 and BSD2. For example, the width, in the first horizontal direction DR1, of the second portion 172 of the middle source/drain contact 170 may continuously decrease closer to the bottom surface of the first portion 171 of the middle source/drain contact 170. Similarly, the width, in the second horizontal direction DR2, of the second portion 172 of the middle source/drain contact 170 may also continuously decrease closer to the bottom surface of the first portion 171 of the middle source/drain contact 170.

In some implementations, the width, in the first horizontal direction DR1, of the first portion 171 of the middle source/drain contact 170 may be greater than the width, in the first horizontal direction DR1, of the second portion 172 of the middle source/drain contact 170. Additionally, the width, in the second horizontal direction DR2, of the first portion 171 of the middle source/drain contact 170 may be greater than the width, in the second horizontal direction DR2, of the second portion 172 of the middle source/drain contact 170.

The middle source/drain contact 170 may be formed as a double film. For example, the middle source/drain contact 170 may include a contact barrier layer 181 and a contact filling layer 182. The contact barrier layer 181 may form the sidewalls and upper surface of the middle source/drain contact 170. For example, the contact barrier layer 181 may form parts of the bottom surface, sidewalls, and upper surface of the first portion 171 of the middle source/drain contact 170. Additionally, the contact barrier layer 181 may form the sidewalls of the first portion 171 of the middle source/drain contact 170. For example, the contact barrier layer 181 may be conformally formed. For example, the contact filling layer 182 may fill the gap in the contact barrier layer 181. Part of the contact filling layer 182 disposed on the first portion 171 of the middle source/drain contact 170 and part of the contact filling layer 182 disposed on the second portion 172 of the middle source/drain contact 170 may be integrally formed.

The contact barrier layer 181 may include any one of Ta, TaN, Ti, TiN, Ru, Co, Ni, nickel boron (NiB), W, WN, tungsten carbonitride (WCN), Zr, zirconium nitride (ZrN), V, vanadium nitride (VN), Nb, NbN, Pt, Ir, and Rh. The contact filling layer 182 may include any one of Al, W, Co, Ru, and Mo.

The first upper source/drain contact UCA1 may be disposed above the first upper source/drain region USD1. The first upper source/drain contact UCA1 may extend into the first upper source/drain region USD1 by penetrating the upper interlayer insulating layer 150 and the second insulating layer 162 in the vertical direction DR3. The first upper source/drain contact UCA1 may be electrically connected to the first upper source/drain region USD1. For example, at least part of the first upper source/drain contact UCA1 may overlap in the vertical direction DR3 with the first portion 171 of the middle source/drain contact 170.

The second upper source/drain contact UCA2 may be disposed above the second upper source/drain region USD2. The second upper source/drain contact UCA2 may extend into the second upper source/drain region USD2 by penetrating the upper interlayer insulating layer 150 and the second insulating layer 162 in the vertical direction DR3. The second upper source/drain contact UCA2 may be spaced apart from the first upper source/drain contact UCA1 in the first horizontal direction DR1. The second upper source/drain contact UCA2 may be electrically connected to the second upper source/drain region USD2. For example, at least part of the second upper source/drain contact UCA2 may overlap with the first portion 171 of the middle source/drain contact 170 in the vertical direction DR3.

The first lower source/drain contact BCA1 may be disposed below the first lower source/drain region BSD1. The first lower source/drain contact BCA1 may extend into the first lower source/drain region BSD1 by penetrating the lower interlayer insulating layer 100, the insulating pattern 101, and the field insulating layer 105 in the vertical direction DR3. The first lower source/drain contact BCA1 may be electrically connected to the first lower source/drain region BSD1.

Similarly, the second lower source/drain contact BCA2 may be disposed below the second lower source/drain region BSD2. The second lower source/drain contact BCA2 may extend into the second lower source/drain region BSD2 by penetrating the lower interlayer insulating layer 100, the insulating pattern 101, and the field insulating layer 105 in the vertical direction DR3. The second lower source/drain contact BCA2 may be electrically connected to the second lower source/drain region BSD2. For example, the second portion 172 of the middle source/drain contact 170 may be disposed between the first and second lower source/drain contacts BCA1 and BCA2. The second portion 172 of the middle source/drain contact 170 may be spaced apart from the first and second lower source/drain contacts BCA1 and BCA2 in the first horizontal direction DR1.

The first upper gate contact UCB1 may be connected to the first upper gate electrode UG1 by penetrating the first capping pattern 141 in the vertical direction DR3. The second upper gate contact UCB2 may be connected to the second upper gate electrode UG2 by penetrating the second capping pattern 142 in the vertical direction DR3. The first lower gate contact BCB1 may be connected to the first lower gate electrode BG1 by penetrating the lower interlayer insulating layer 100 and the field insulating layer 105 in the vertical direction DR3. The second lower gate contact BCB2 may be connected to the second lower gate electrode BG2 by penetrating the lower interlayer insulating layer 100 and field insulating layer 105 in the vertical direction DR3.

In some implementations, the first and second upper source/drain contacts UCA1 and UCA2, the first and second lower source/drain contacts BCA1 and BCA2, the first and second upper gate contacts UCB1 and UCB2, and the first and second lower gate contacts BCB1 and BCB2 may be formed as double films. For example, the first and second upper source/drain contacts UCA1 and UCA2, the first and second lower source/drain contacts BCA1 and BCA2, the first and second upper gate contacts UCB1 and UCB2, and the first and second lower gate contacts BCB1 and BCB2 may each include the contact barrier layer 181 and the contact filling layer 182, and further details thereof will be omitted here.

The lower silicide layer BSL may be disposed between the first lower source/drain contact BCA1 and the first lower source/drain region BSD1. The lower silicide layer BSL may also be disposed between the second lower source/drain contact BCA2 and the second lower source/drain region BSD2. The middle silicide layer MSL may be disposed between the first portion 171 of the middle source/drain contact 170 and the first middle source/drain region MSD1. The middle silicide layer MSL may also be disposed between the first portion 171 of the middle source/drain contact 170 and the second middle source/drain region MSD2. The upper silicide layer USL may be disposed between the first upper source/drain contact UCA1 and the first upper source/drain region USD1. The upper silicide layer USL may also be disposed between the second upper source/drain contact UCA2 and the second upper source/drain region USD2. In some implementations, the lower silicide layer BSL, the middle silicide layer MSL, and the upper silicide layer USL may all include a metal silicide material.

The first via V1 may be connected to the first upper gate contact UCB1 by penetrating the upper interlayer insulating layer 150 in the vertical direction DR3. The second via V2 may be connected to the second upper gate contact UCB2 by penetrating the upper interlayer insulating layer 150 in the vertical direction DR3. In some implementations, the first and second vias V1 and V2 may be formed as double films. For example, each of the first and second vias V1 and V2 may include a via barrier layer 191 and a via filling layer 192. The barrier via barrier layer 191 may form the sidewalls and bottom surface of each of the first and second vias V1 and V2. The via filling layer 192 may fill the gaps in the via barrier layer 191.

In some implementations, the via barrier layer 191 may include one of Ta, TaN, Ti, TiN, Ru, Co, Ni, NiB, W, WN, WCN, Zr, ZrN, V, VN, Nb, NbN, Pt, Ir, and Rh. In some implementations, the via filling layer 192 may include one of Al, W, Co, Ru, and Mo.

The semiconductor device according to some implementations may form one PMOS transistor and two NMOS transistors where the first gate electrode (BG1, MG1, and UG1) is stacked in the vertical direction DR3, and form one PMOS transistor and two NMOS transistor where the second gate electrodes (BG2, MG2, and UG2) is stacked in the vertical direction DR3. That is, the semiconductor device according to some implementations may be an SRAM semiconductor device including two PMOS transistor and four NMOS transistors that are stacked in the vertical direction DR3.

Additionally, the semiconductor device according to some implementations may include the middle source/drain contact 170 that is electrically connected to both the first and second middle source/drain regions MSD1 and MSD2 between the first gate electrode (BG1, MG1, and UG1) and the second gate electrodes (BG2, MG2, and UG2). The middle source/drain contact 170 may extend toward the lower interlayer insulating layer 100, which corresponds to the backside of the semiconductor device according to some implementations. Accordingly, the integration density of an SRAM semiconductor device can be improved.

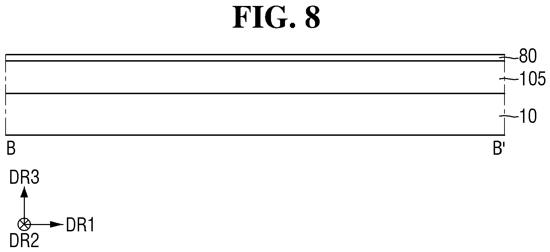

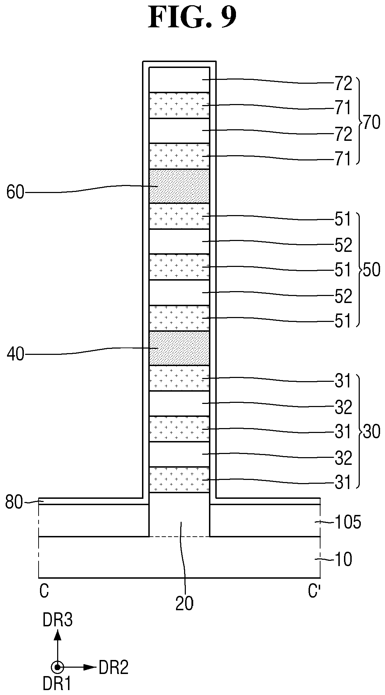

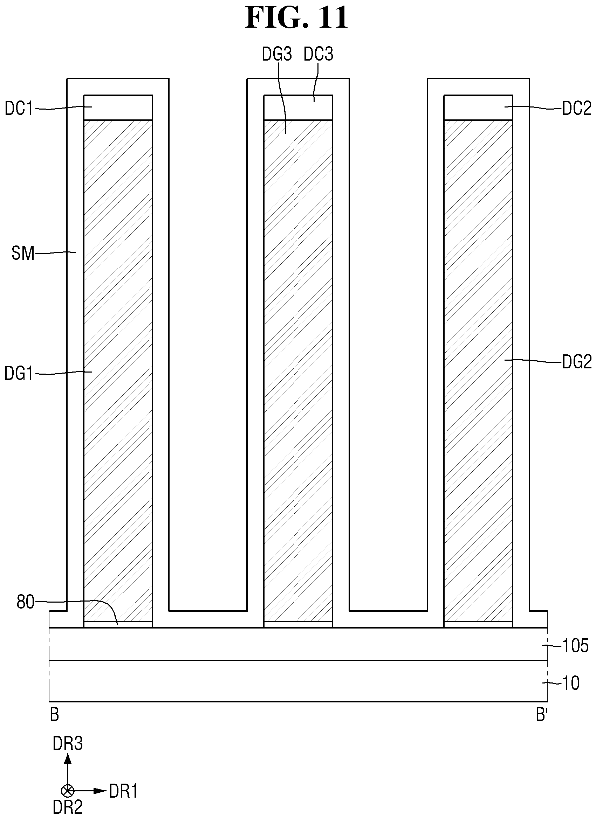

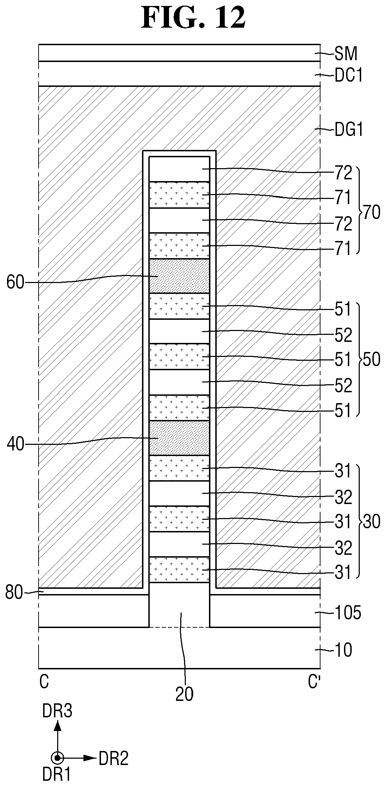

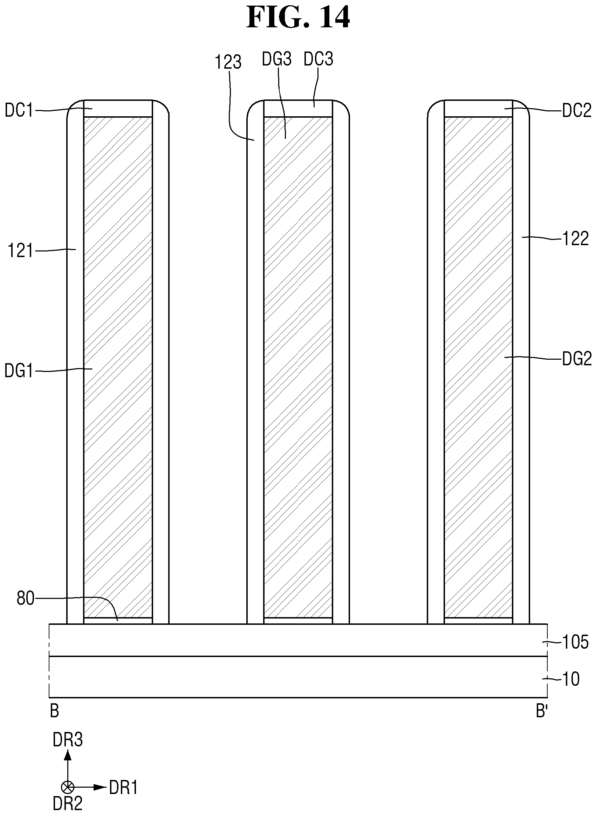

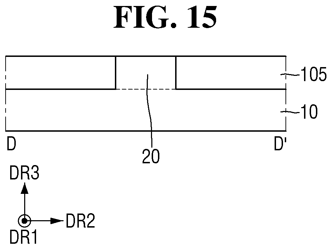

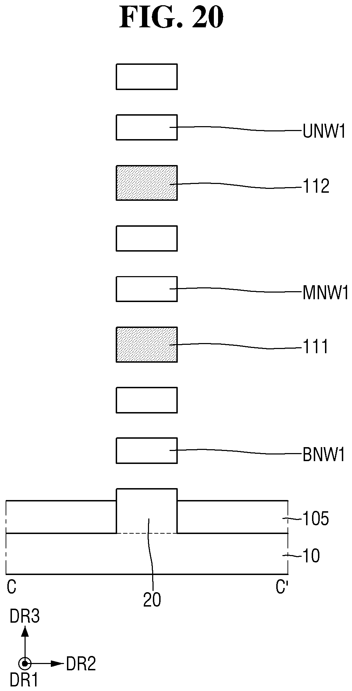

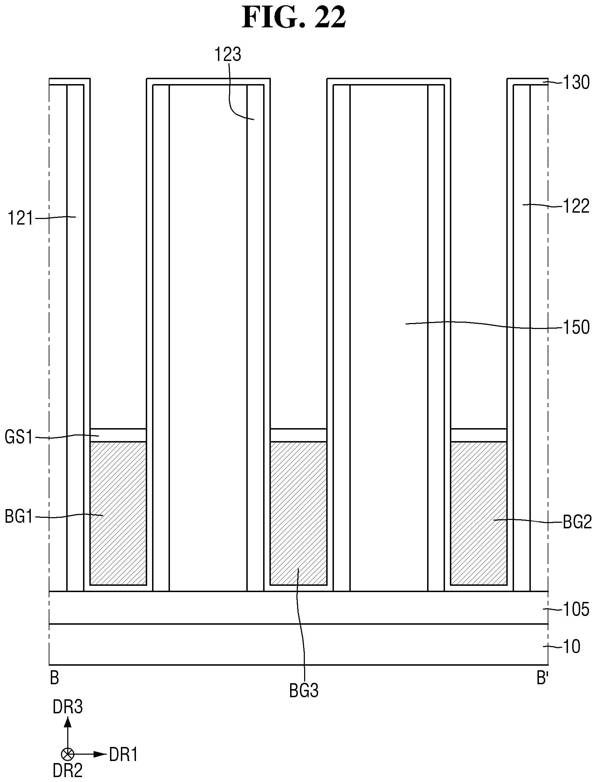

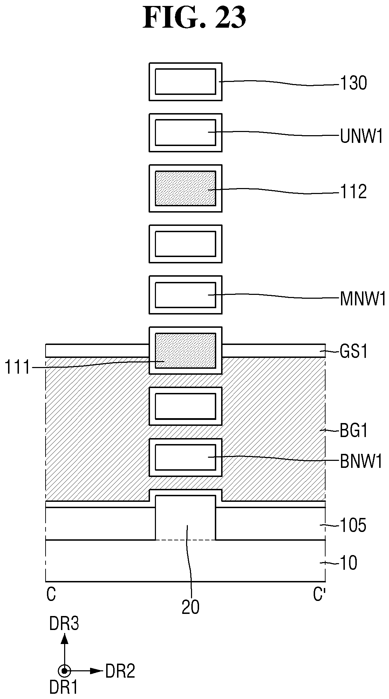

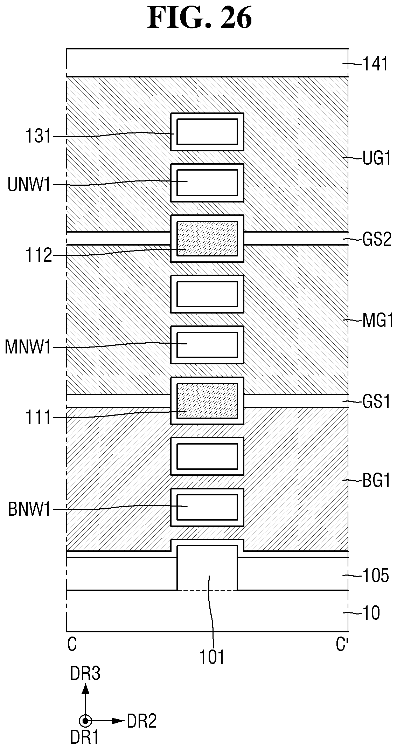

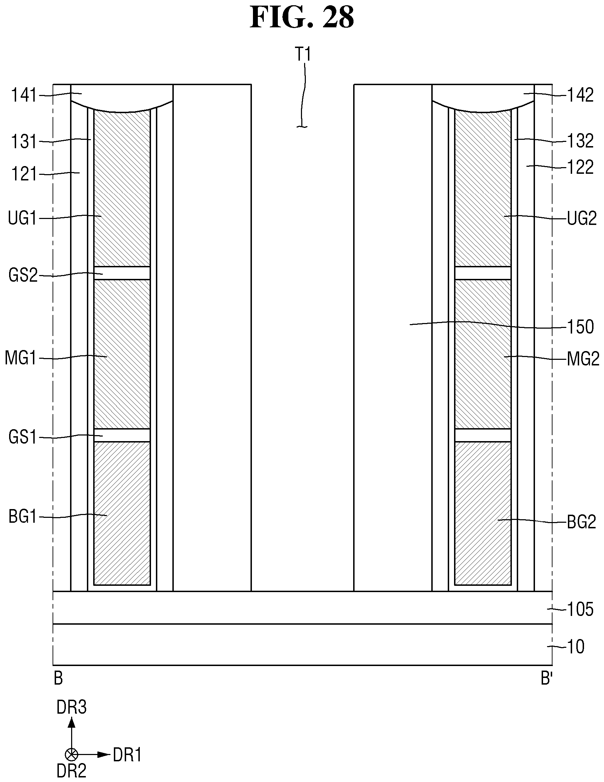

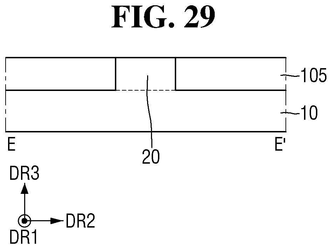

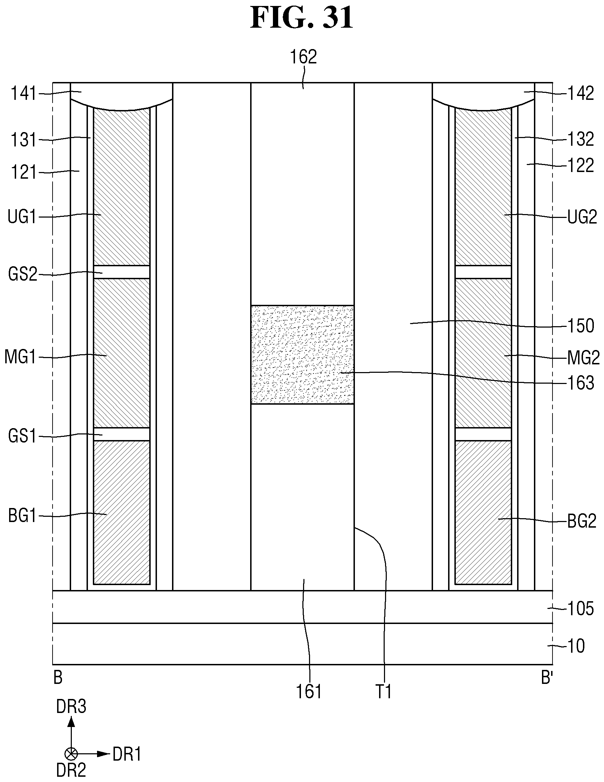

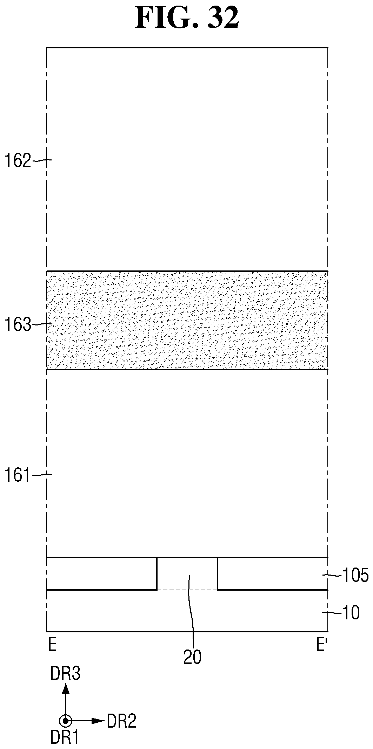

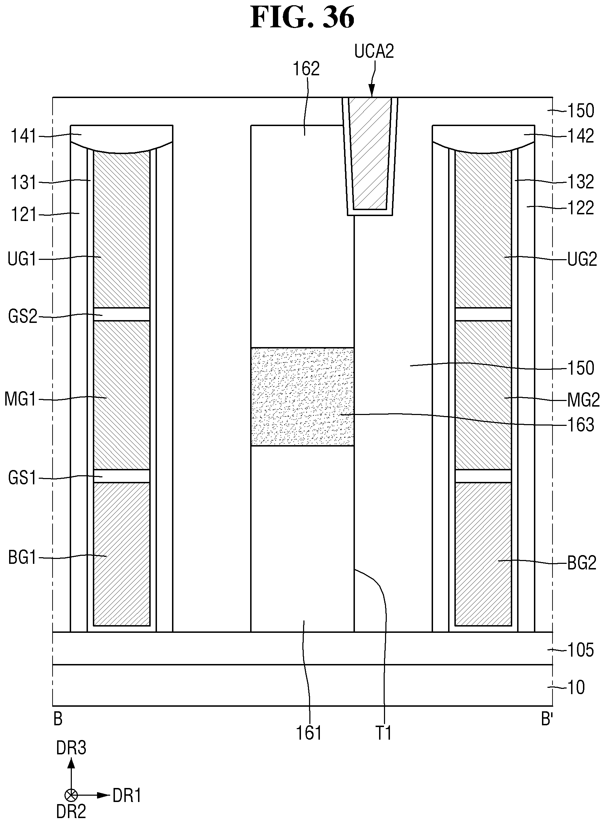

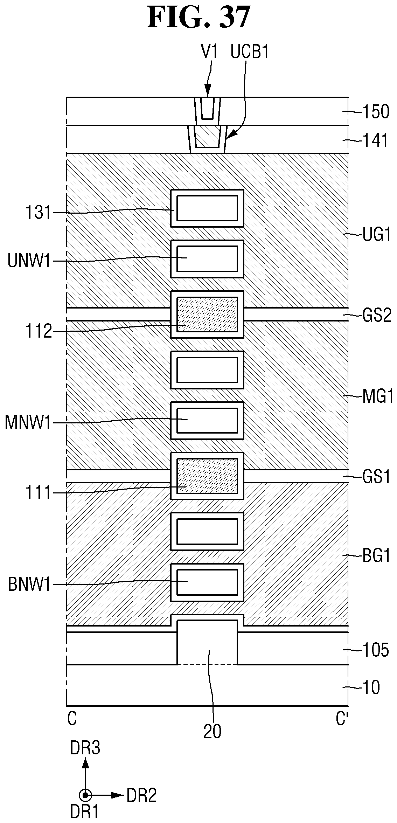

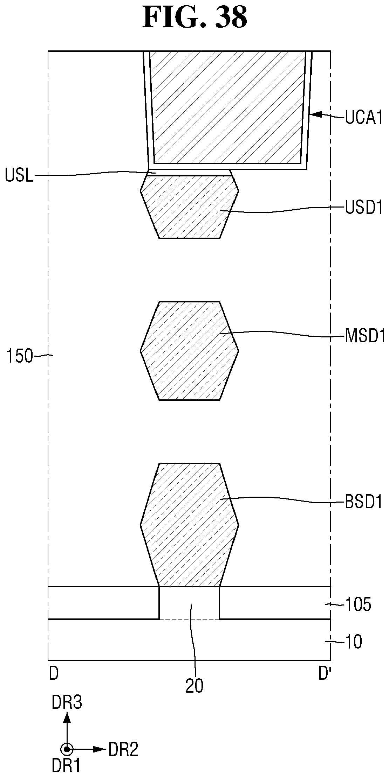

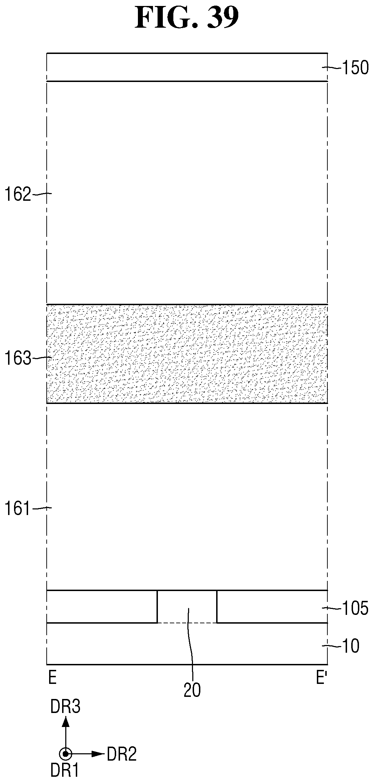

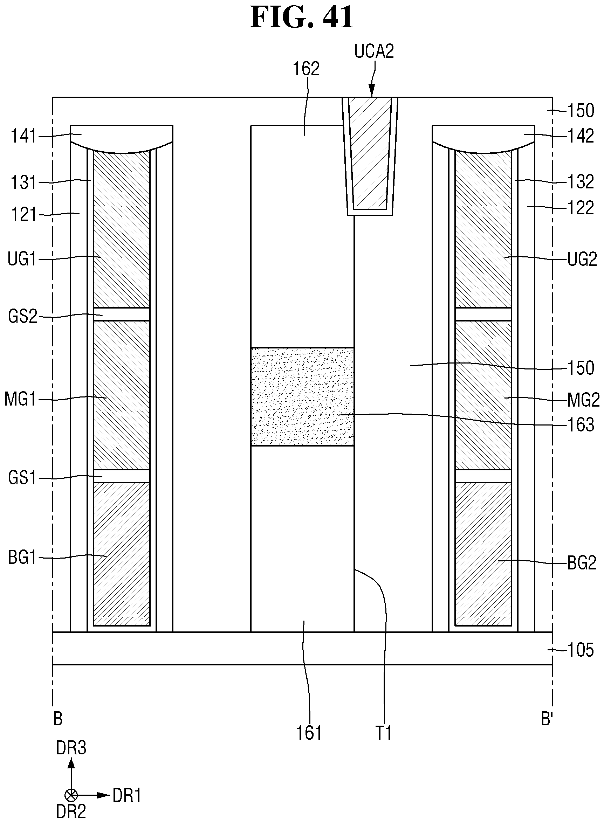

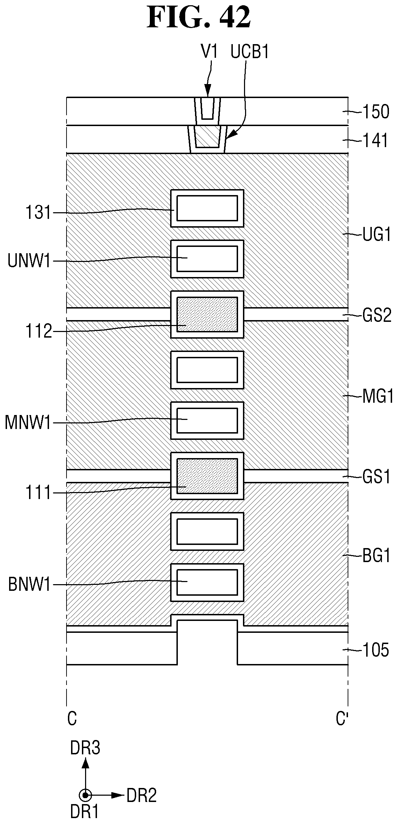

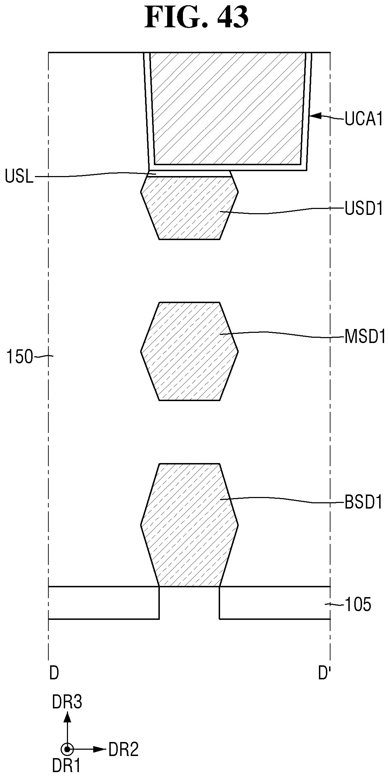

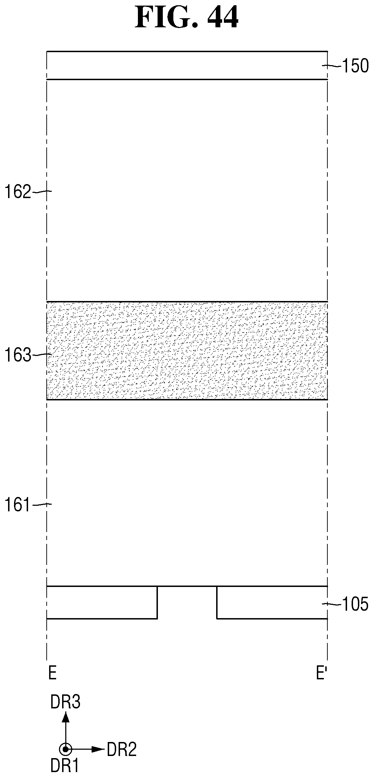

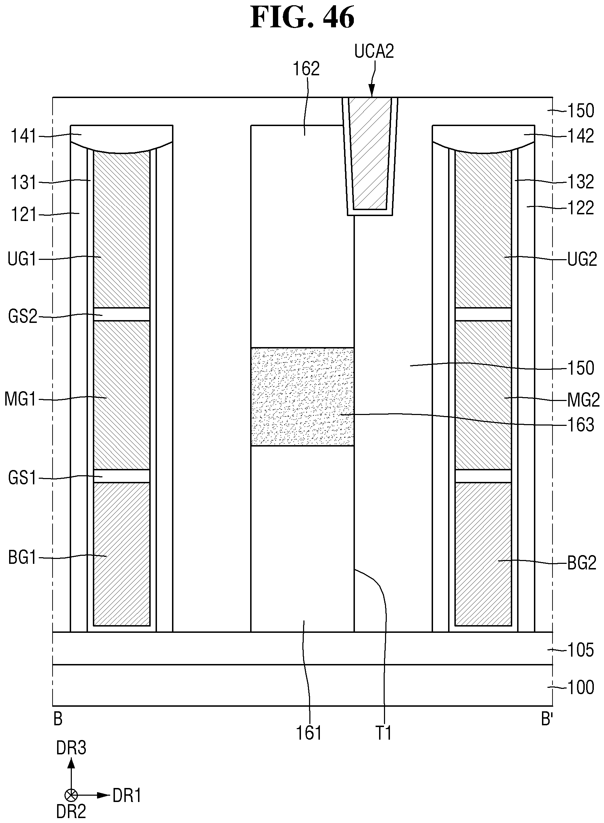

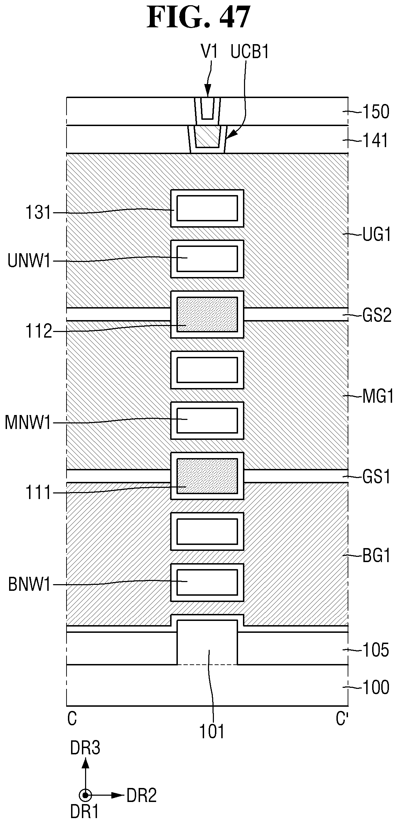

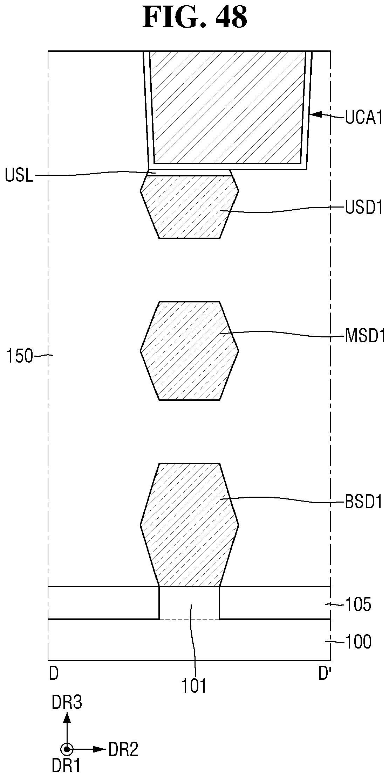

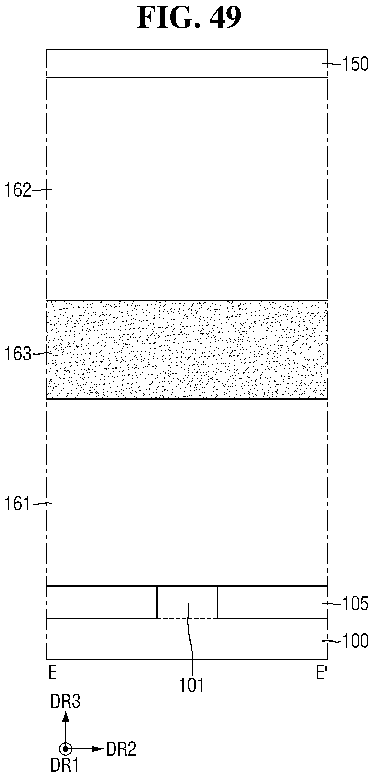

A method of fabricating a semiconductor device according to some implementations will hereinafter be described with reference to FIGS. 2 through 53.

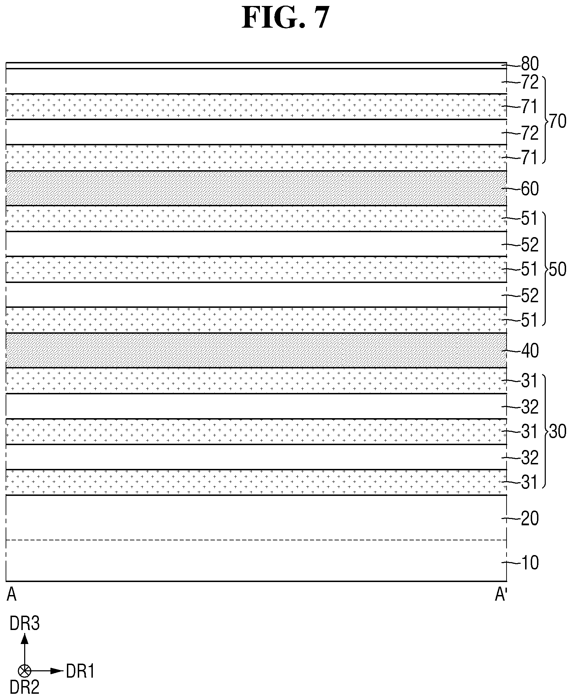

FIGS. 7 through 53 are cross-sectional views illustrating intermediate steps of a method of fabricating a semiconductor device according to some implementations.

Referring to FIGS. 7 through 9, a substrate 10 is provided. The substrate 10 may be a Si or silicon-on-insulator (SOI) substrate, but the present disclosure is not limited thereto. The substrate 10 may also include a material such as SiGe, SiGe-on-insulator (SGOI), antimonide indium, a lead telluride compound, indium arsenide, indium phosphide, gallium antimonide, or antimonide gallium, but the present disclosure is not limited thereto.

Thereafter, a first stack structure 30, the first separation material layer 40, the second stack structure 50, the second separation material layer 60, and the third stack structure 70 may be sequentially formed on the upper surface of the substrate 10. The first stack structure 30 includes first semiconductor layers 31 and second semiconductor layers 32, and the first semiconductor layers 31 and the second semiconductor layers 32 may be stacked on the upper surface of the substrate 10, alternating with one another. For example, first semiconductor layers 31 may be formed at the lowermost and uppermost parts of the first stack structure 30. The second stack structure 50 includes third semiconductor layers 51 and fourth semiconductor layers 52, and the third semiconductor layers 51 and the fourth semiconductor layers 52 may be stacked on the upper surface of the first separation material layer 40, alternating with one another. For example, third semiconductor layers 51 may be formed at the lowermost and uppermost parts of the second stack structure 50. The third stack structure 70 includes fifth semiconductor layers 71 and sixth semiconductor layers 72, and the fifth semiconductor layers 71 and the sixth semiconductor layers 72 may be stacked on the upper surface of the second separation material layer 60, alternating with one another. For example, a fifth semiconductor layer 71 may be formed at the lowermost part of the third stack structure 70, and a sixth semiconductor layer 72 may be formed at the uppermost part of the third stack structure 70.

In some implementations, the first semiconductor layers 31, the third semiconductor layers 51, and the fifth semiconductor layers 71 may include SiGe. In some implementations, the second semiconductor layers 32, the fourth semiconductor layers 52, and the sixth semiconductor layers 72 may include Si. In some implementations, the first and second separation material layers 40 and 60 may include at least one of SiN, SiOCN, SiBCN, SiCN, SiON, and a combination thereof.

Thereafter, parts of the first stack structure 30, the first separation material layer 40, the second stack structure 50, the second separation material layer 60, and the third stack structure 70 may be etched. While the first stack structure 30, the first separation material layer 40, the second stack structure 50, the second separation material layer 60, and the third stack structure 70 are being etched, part of the substrate 10 may also be etched. Through this etching process, an active pattern 20 may be defined on the upper surface of the substrate 10, below the first stack structure 30. The active pattern 20 may protrude in a vertical direction DR3 from the upper surface of the substrate 10. The active pattern 20 may extend in a first horizontal direction DR1.

Thereafter, a field insulating layer 105 may be formed on the upper surface of the substrate 10. The field insulating layer 105 may surround the sidewalls of the active pattern 20. For example, the upper surface of the active pattern 20 may be formed higher than the upper surface of the field insulating layer 105. Thereafter, a pad oxide layer 80 may be formed to cover the upper surface of the field insulating layer 105, the exposed sidewalls of the active pattern 20, the sidewalls of the first stack structure 30, the sidewalls of the first separation material layer 40, the sidewalls of the second stack structure 50, the sidewalls of the second separation material layer 60, and the sidewalls and upper surface of the third stack structure 70. In some implementations, the pad oxide layer 80 may be conformally formed. In some implementations, the pad oxide layer 80 may include SiO₂.

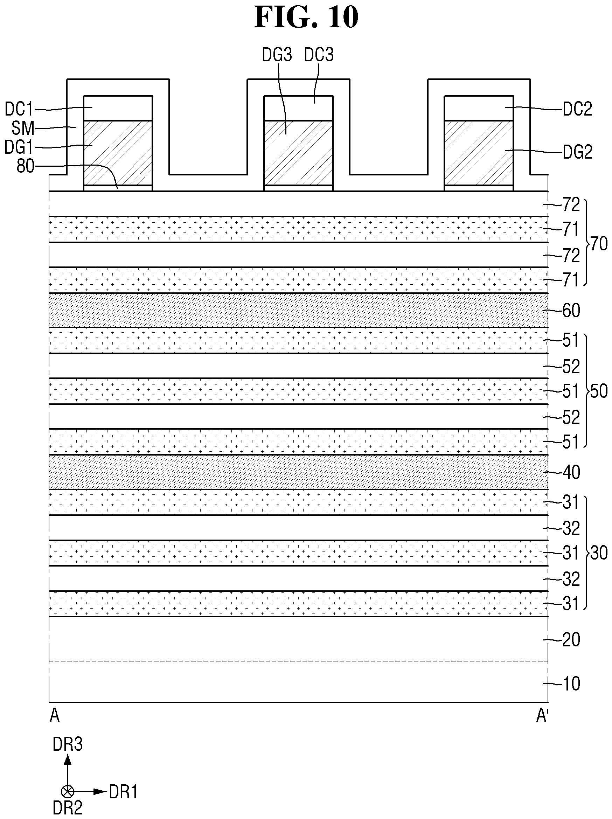

Referring to FIGS. 10 through 12, first, second, and third dummy gates DG1, DG2, and DG3 and first, second, and third dummy capping patterns DC1, DC2, and DC3 may be formed on the pad oxide layer 80, on the third stack structure 70 and the field insulating layer 105. The first, second, and third dummy capping patterns DC1, DC2, and DC3 may be formed on the first, second, and third dummy gates DG1, DG2, and DG3, respectively. The first, second, and third dummy gates DG1, DG2, and DG3 and the first, second, and third dummy capping patterns DC1, DC2, and DC3 may extend in a second horizontal direction DR2. The third dummy gate DG3 may be spaced apart from the first dummy gate DG1 in the first horizontal direction DR1. The second dummy gate DG2 may be spaced apart from the third dummy gate DG3 in the first horizontal direction DR1. That is, the third dummy gate DG3 may be formed between the first and second dummy gates DG1 and DG2. During the formation of the first, second, and third dummy gates DG1, DG2, and DG3 and the first, second, and third dummy capping patterns DC1, DC2, and DC3, the entire pad oxide layer 80 except for portions overlapping with the first, second, and third dummy gates DG1, DG2, and DG3 in the vertical direction DR3 on the substrate 10 may be removed.

Thereafter, a spacer material layer SM may be formed to cover the upper surface of the field insulating layer 105, the sidewalls of the first stack structure 30, the sidewalls of the first separation material layer 40, the sidewalls of the second stack structure 50, the sidewalls of the second separation material layer 60, the sidewalls and upper surface of the third stack structure 70, the sidewalls of each of the first, second, and third dummy gates DG1, DG2, and DG3, and the sidewalls and upper surface of each of the first, second, and third dummy capping patterns DC1, DC2, and DC3. For example, the spacer material layer SM may be conformally formed. The spacer material layer SM may include, for example, at least one of SiN, SiON, SiO₂, SiOCN, SiBN, SiOBN, SiOC, and a combination thereof.

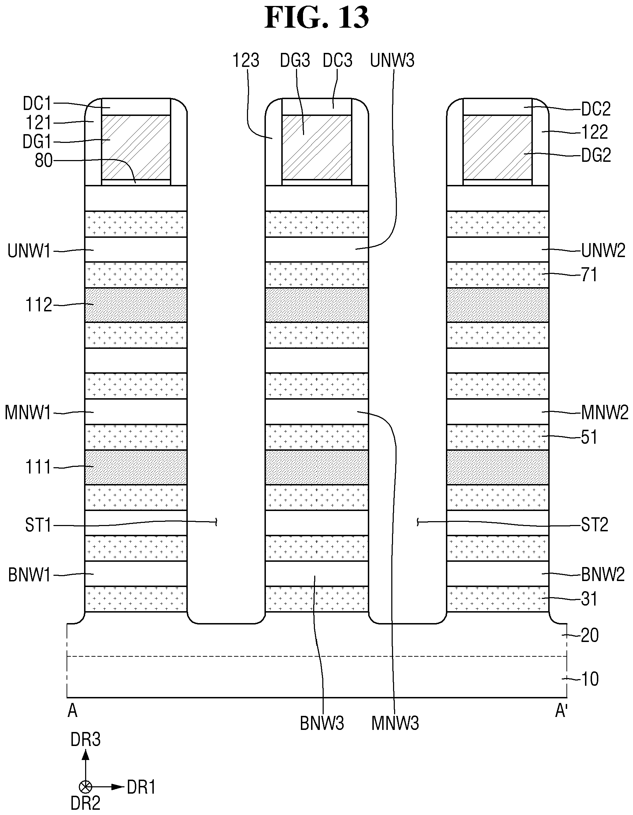

Referring to FIGS. 13 through 15, first and second source/drain trenches ST1 and ST2 may be formed by etching the first, second, and third stack structures 30, 50, and 70 and the first and second separation material layers 40 and 60 of FIG. 10 using the first, second, and third dummy gates DG1, DG2, and DG3 and the first, second, and third dummy capping patterns DC1, DC2, and DC3 as a mask. The first source/drain trench ST1 may be formed between the first and third dummy gates DG1 and DG3. The second source/drain trench ST2 may be formed between the second and third dummy gates DG2 and DG3. In some implementations, at least parts of the first and second source/drain trenches ST1 and ST2 may extend into the active pattern 20.

During the formation of the first and second source/drain trenches ST1 and ST2, parts of the first, second, and third dummy capping patterns DC1, DC2, and DC3 and parts of the spacer material layer SM of FIG. 10) formed on the upper surfaces of the first, second, and third dummy capping patterns DC1, DC2, and DC3 may be removed. Parts of the spacer material layer SM that remain on the sidewalls of the first, second, and third dummy capping patterns DC1, DC2, and DC3 and the sidewalls of the first, second, and third dummy gates DG1, DG2, and DG3 may be defined as first, second, and third gate spacers 121, 122, and 123. For example, after the formation of the first and second source/drain trenches ST1 and ST2, parts of the first and second separation material layers 40 and 60 of FIG. 10 that remain below the first, second, and third dummy gates DG1, DG2, and DG3 may be defined as first and second stack separation layers 111 and 112.

After the formation of the first and second source/drain trenches ST1 and ST2, parts of the second semiconductor layers 32, fourth semiconductor layers 52, and sixth semiconductor layers 72 of FIG. 10 that remain below the first dummy gate DG1 may be defined as first plurality of lower nanosheets BNW1, first plurality of middle nanosheets MNW1, and first plurality of upper nanosheets UNW1, respectively. Similarly, after the formation of the first and second source/drain trenches ST1 and ST2, parts of the second semiconductor layers 32, fourth semiconductor layers 52, and sixth semiconductor layers 72 that remain below the second dummy gate DG2 may be defined as second plurality of lower nanosheets BNW2, second plurality of middle nanosheets MNW2, and second plurality of upper nanosheets UNW2, respectively. Furthermore, after the formation of the first and second source/drain trenches ST1 and ST2, parts of the second semiconductor layers 32, fourth semiconductor layers 52, and sixth semiconductor layers 72 that remain below the third dummy gate DG3 may be defined as third plurality of lower nanosheets BNW3, third plurality of middle nanosheets MNW3, and third plurality of upper nanosheets UNW3, respectively.

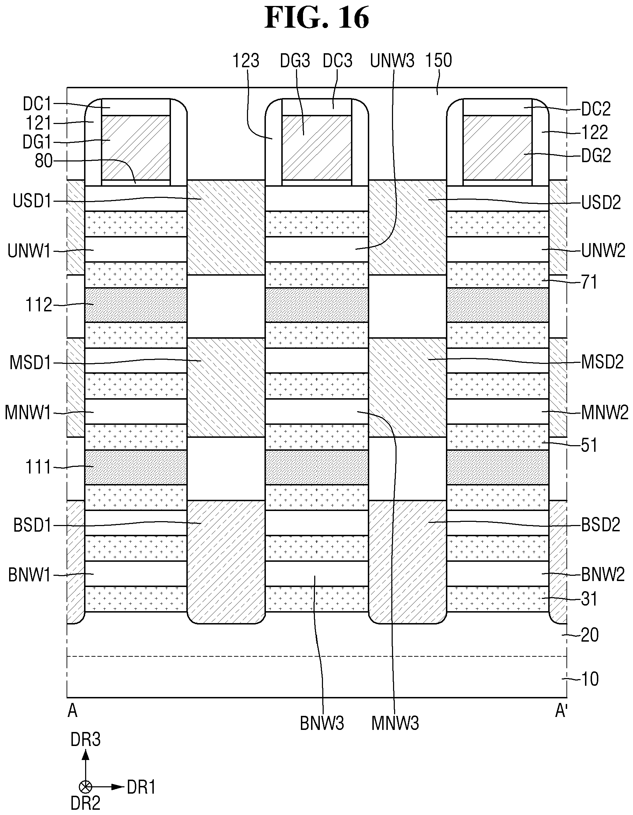

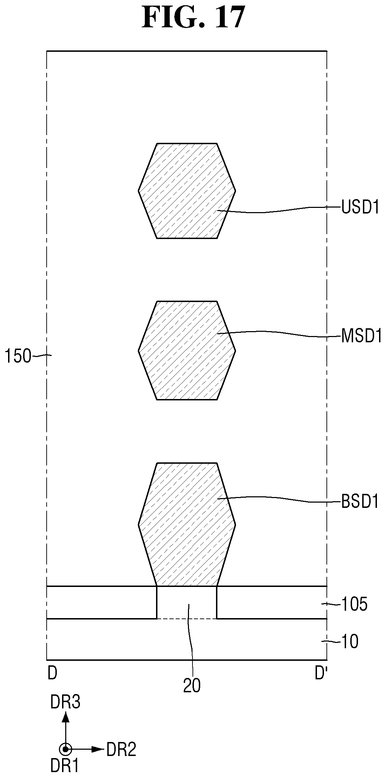

Referring to FIGS. 16 and 17, a first lower source/drain region BSD1, a first middle source/drain region MSD1, and a first upper source/drain region USD1 may be formed within the first source/drain trench ST1 of FIG. 13. Additionally, a second lower source/drain region BSD2, a second middle source/drain region MSD2, and a second upper source/drain region USD2 may be formed with the second source/drain trench ST2 of FIG. 13. Moreover, an upper interlayer insulating layer 150 may be formed to cover the first and second lower source/drain regions BSD1 and BSD2, the first and second middle source/drain regions MSD1 and MSD2, and the first and second upper source/drain regions USD1 and USD2. For example, the upper interlayer insulating layer 150 may be formed to cover the upper surfaces of the first, second, and third dummy capping patterns DC1, DC2, and DC3.

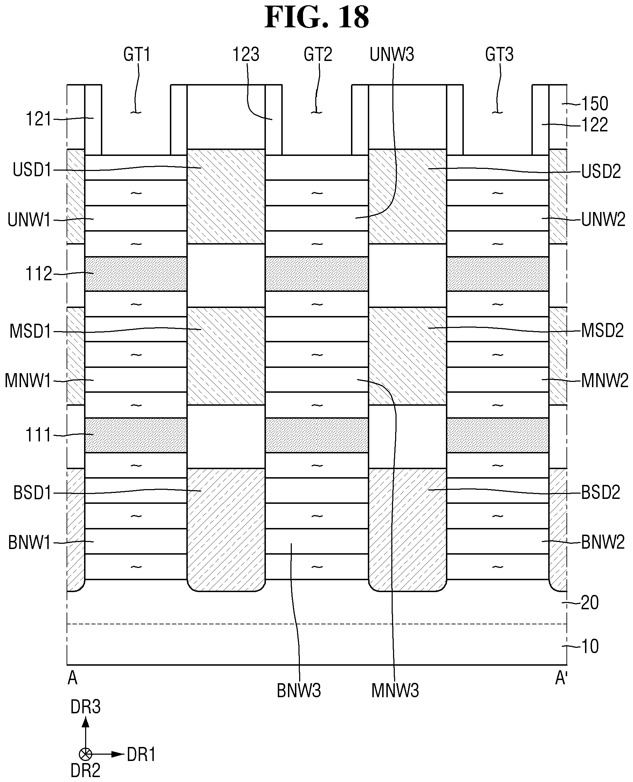

Referring to FIGS. 18 through 20, through a planarization process, the upper surfaces of the first, second, and third dummy gates DG1, DG2, and DG3 may be exposed. Thereafter, the first, second, and third dummy gates DG1, DG2, and DG3, the pad oxide layer 80, the first semiconductor layers 31, the third semiconductor layers 51, and the fifth semiconductor layers 71 of FIG. 16 may be etched.

For example, parts of the first dummy gate DG1 and its underlying components that are etched may be defined as a first gate trench GT1, parts of the second dummy gate DG2 and its underlying components that are etched may be defined as a second gate trench GT2, and parts of the third dummy gate DG3 and its underlying components that are etched may be defined as a third gate trench GT3.

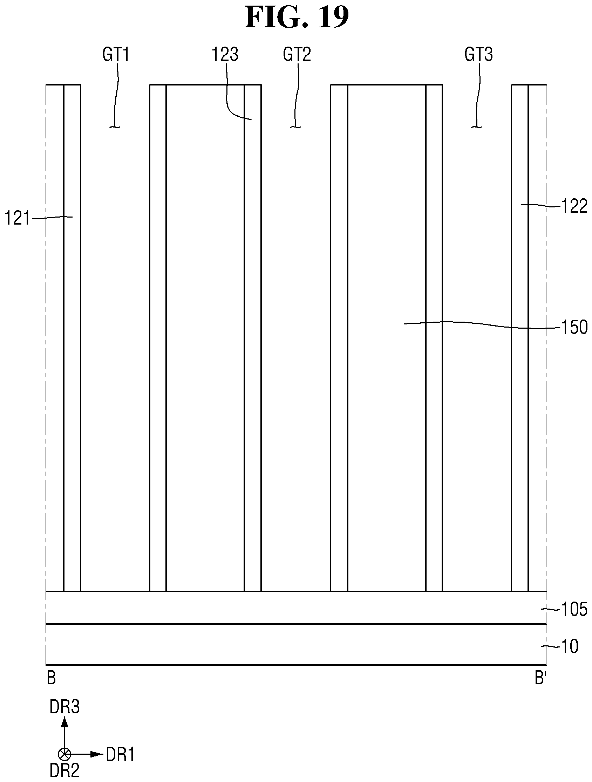

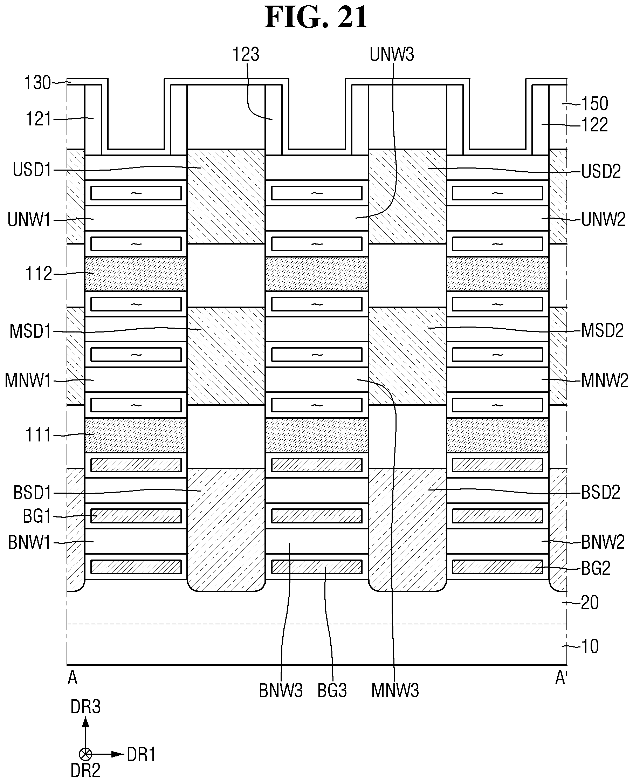

Referring to FIGS. 21 through 23, a gate insulating material layer 130 may be formed along the sidewalls and bottom surface of each of the first, second, and third gate trenches GT1, GT2, and GT3 of FIGS. 18 and 19. The gate insulating material layer 130 may be formed along the surfaces of the first plurality of lower nanosheets BNW1, the surfaces of the second plurality of lower nanosheets BNW2, the surfaces of first plurality of middle nanosheets MNW1, the surfaces of second plurality of middle nanosheets MNW2, the surfaces of the first plurality of upper nanosheets UNW1, the surfaces of the second plurality of upper nanosheets UNW2, and the surfaces of the first and second stack separation layers 111 and 112. Additionally, the gate insulating material layer 130 may also be formed on the upper surfaces of the upper interlayer insulating layer 150 and the first, second, and third gate spacers 121, 122, and 123. In some implementations, the gate insulating material layer 130 may be conformally formed. For example, the gate insulating material layer 130 may be conformally formed and may include a high-k dielectric material.

Thereafter, a first lower gate electrode BG1 may be formed, surrounding parts of the first plurality of lower nanosheets BNW1 and the first stack separation layer 111, within the first gate trench GT1 of FIGS. 18 and 19. A second lower gate electrode BG2 may be formed, surrounding parts of the second plurality of lower nanosheets BNW2 and the first stack separation layer 111, within the second gate trench GT2 of FIGS. 18 and 19. A third lower gate electrode BG3 may be formed, surrounding parts of the third plurality of lower nanosheets BNW3 and the first stack separation layer 111, within the third gate trench GT3 of FIGS. 18 and 19.

Thereafter, a first gate separation layer GS1 may be formed on the upper surface of each of the first, second, and third lower gate electrodes BG1, BG2, and BG3, within each of the first, second, and third gate trenches GT1, GT2, and GT3 of FIGS. 18 and 19. For example, the first gate separation layer GS1 may be formed on the sidewalls of the first stack separation layer 111.

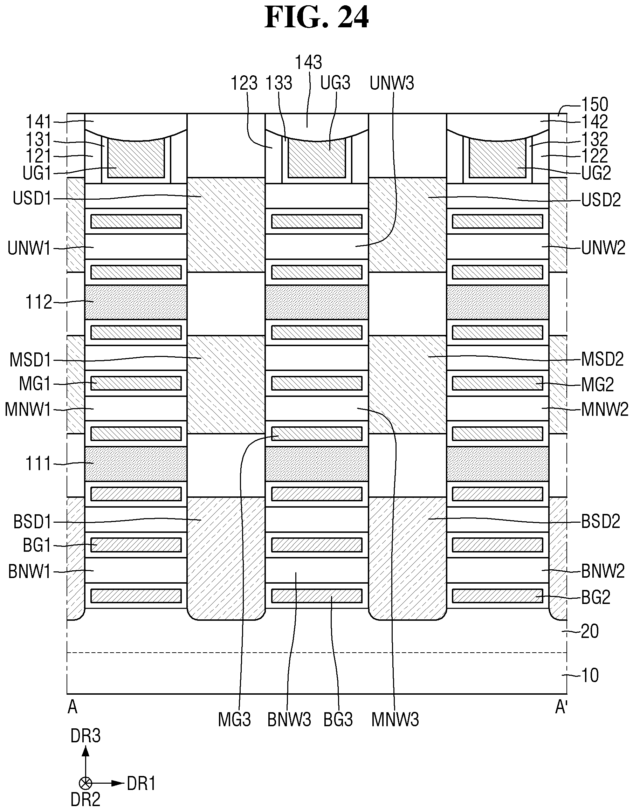

Referring to FIGS. 24 through 26, a first middle gate electrode MG1 may be formed, surrounding other parts of the first stack separation layer 111, the first plurality of middle nanosheets MNW1, and the second stack separation layer 112, within the first gate trench GT1 of FIGS. 18 and 19. A second middle gate electrode MG2 may be formed, surrounding other parts of the first stack separation layer 111, the second plurality of middle nanosheets MNW2, and the second stack separation layer 112, within the second gate trench GT2 of FIGS. 18 and 19. A third middle gate electrode MG3 may be formed, surrounding parts of the first stack separation layer 111, the third plurality of middle nanosheets MNW3, and the second stack separation layer 112, within the third gate trench GT3 of FIGS. 18 and 19.

Thereafter, a second gate separation layer GS2 may be formed on the upper surface of each of the first, second, and third middle gate electrodes MG1, MG2, and MG3, within each of the first to third gate trenches GT1, GT2, GT3 of FIGS. 18 and 19. For example, the second gate separation layer GS2 may be formed on the sidewalls of the second stack separation layer 112.

Thereafter, a first upper gate electrode UG1 may be formed, surrounding other parts of the second stack separation layer 112 and the first plurality of upper nanosheets UNW1, within the first gate trench GT1 of FIGS. 18 and 19. A second upper gate electrode UG2 may be formed, surrounding other parts of the second stack separation layer 112 and the second plurality of upper nanosheets UNW2, within the second gate trench GT2 of FIGS. 18 and 19. A third upper gate electrode UG3 may be formed, surrounding other parts of the second stack separation layer 112 and the third set of plurality of upper nanosheets UNW3, within the third gate trench GT3 of FIGS. 18 and 19.

Thereafter, the upper surfaces of the first, second, and third gate spacers 121, 122, and 123, and the upper surfaces of the first, second, and third upper gate electrodes UG1, UG2, and UG3 may be exposed by performing a planarization process. Parts of the gate insulating material layer 130 that remain after the planarization process may be defined as first, second, and third gate insulating layers 131, 132, and 133. Thereafter, after etching parts of the first, second, and third gate spacers 121, 122, 123, first, second, and third capping patterns 141, 142, and 143 may be formed on the first, second, and third gate spacers 121, 122, 123, respectively, the first, second, and third gate insulating layers 131, 132, and 133, respectively, and the first, second, and third upper gate electrodes UG1, UG2, and UG3, respectively.

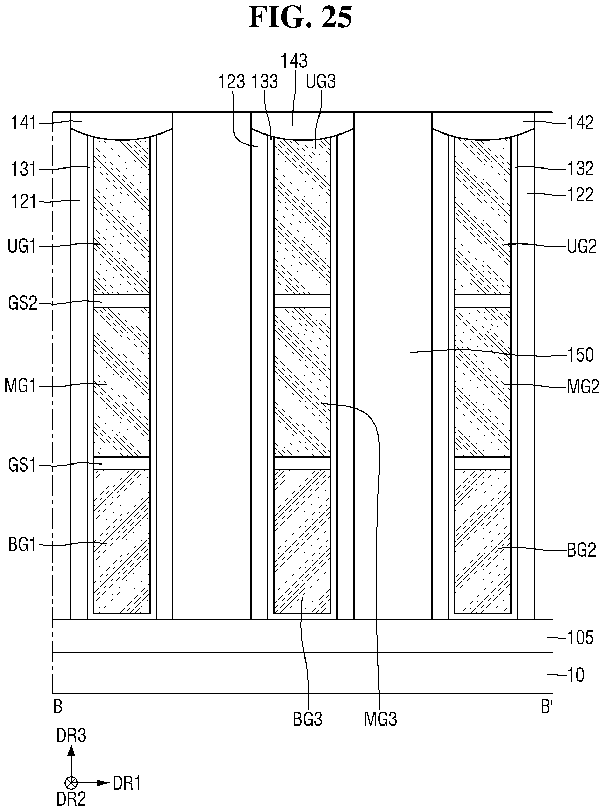

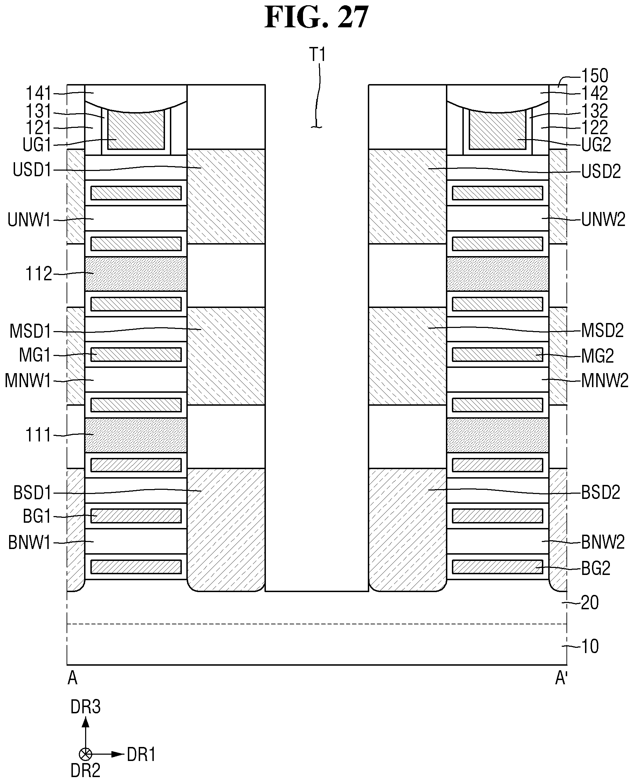

Referring to FIGS. 27 through 29, a first trench T1 may be formed by etching parts of the third gate spacer 123, the third gate insulating layer 133, the third capping pattern 143, the third plurality of lower nanosheets BNW3, the third plurality of middle nanosheets MNW3, the third plurality of upper nanosheets UNW3, the third lower gate electrode BG3, the third middle gate electrode MG3, the third upper gate electrode UG3, the first stack separation layer 111, the second stack separation layer 112, the first gate separation layer GS1, and the second gate separation layer GS2 of FIGS. 24 and 25.

In some implementations, the first trench T1 may expose the sidewalls, in the first horizontal direction DR1, of each of the first and second lower source/drain regions BSD1 and BSD2, the first and second middle source/drain regions MSD1 and MSD2, and the first and second upper source/drain regions USD1 and USD2. The bottom surface of the first trench T1 may be defined by the upper surface of the active pattern 20 and the upper surface of the field insulating layer 105.

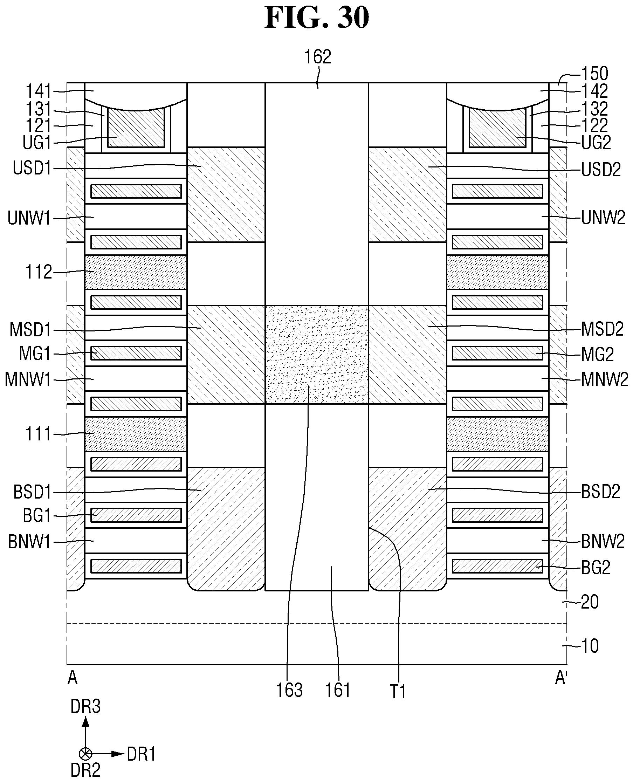

Referring to FIGS. 30 through 32, a first insulating layer 161, a third insulating layer 163, and a second insulating layer 162 may be sequentially formed within the first trench T1. For example, the bottom surface of the third insulating layer 163 may be formed on the same plane as the bottom surfaces of the first and second middle source/drain regions MSD1 and MSD2. Additionally, the upper surface of the third insulating layer 163 may be formed on the same plane as the upper surfaces of the first and second middle source/drain regions MSD1 and MSD2.

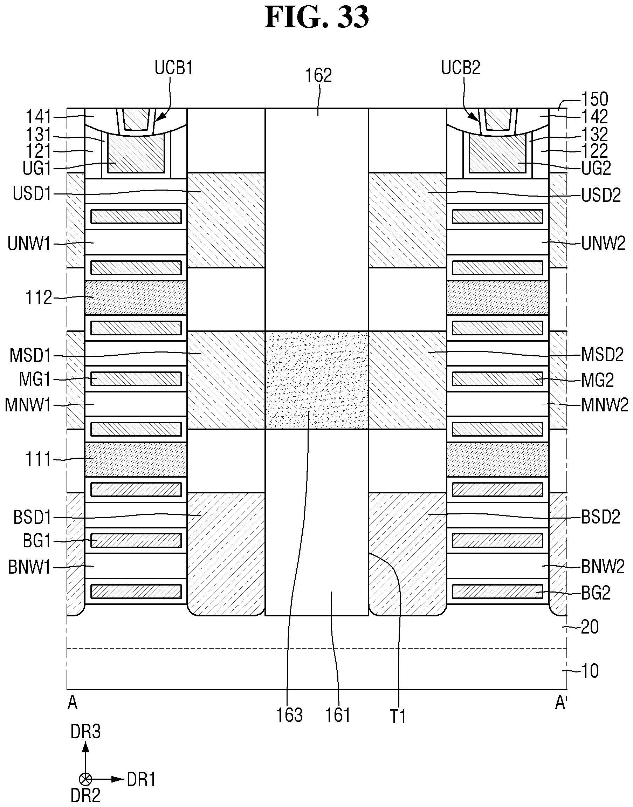

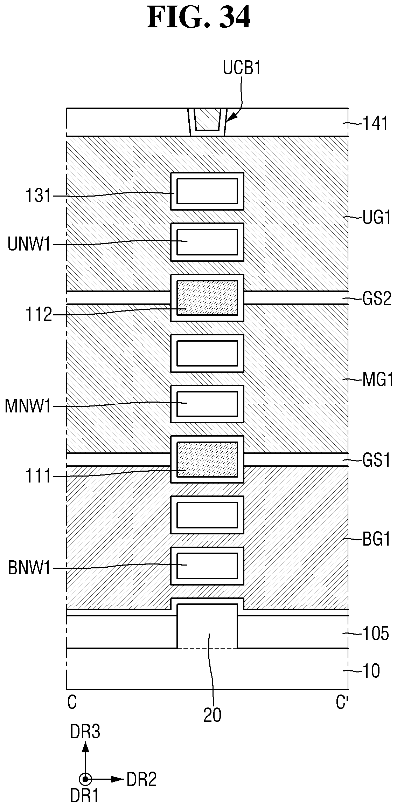

Referring to FIGS. 33 and 34, a first upper gate contact UCB1, which is connected to the first upper gate electrode UG1 by penetrating the first capping pattern 141 in the vertical direction DR3, may be formed. Additionally, a second upper gate contact UCB2, which is connected to the second upper gate electrode UG2 by penetrating the second capping pattern 142 in the vertical direction DR3, may be formed.

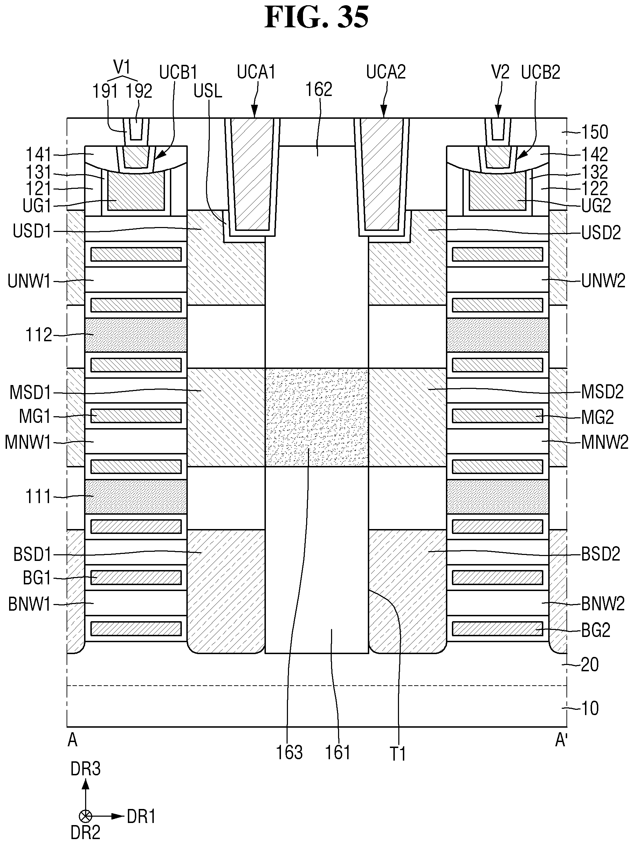

Referring to FIGS. 35 through 39, an upper interlayer insulating layer 150 may be additionally formed on the upper surfaces of the first capping pattern 141, the second capping pattern 142, the upper interlayer insulating layer 150, and the second insulating layer 162.

Thereafter, a first upper source/drain contact UCA1, which extends into the first upper source/drain region USD1 by penetrating the upper interlayer insulating layer 150 and the second insulating layer 162 in the vertical direction DR3, may be formed. A second upper source/drain contact UCA2, which extends into the second upper source/drain region USD2 by penetrating the upper interlayer insulating layer 150 and the second insulating layer 162 in the vertical direction DR3, may also be formed. An upper silicide layer USL may be formed between the first upper source/drain contact UCA1 and the first upper source/drain region USD1 and between the second upper source/drain contact UCA2 and the second upper source/drain region USD2, respectively. A first via V1, which is connected to the first upper gate contact UCB1 by penetrating the upper interlayer insulating layer 150 in the vertical direction DR3, may be formed. A second via V2, which is connected to the second upper gate contact UCB2 by penetrating the upper interlayer insulating layer 150 in the vertical direction DR3, may also be formed.

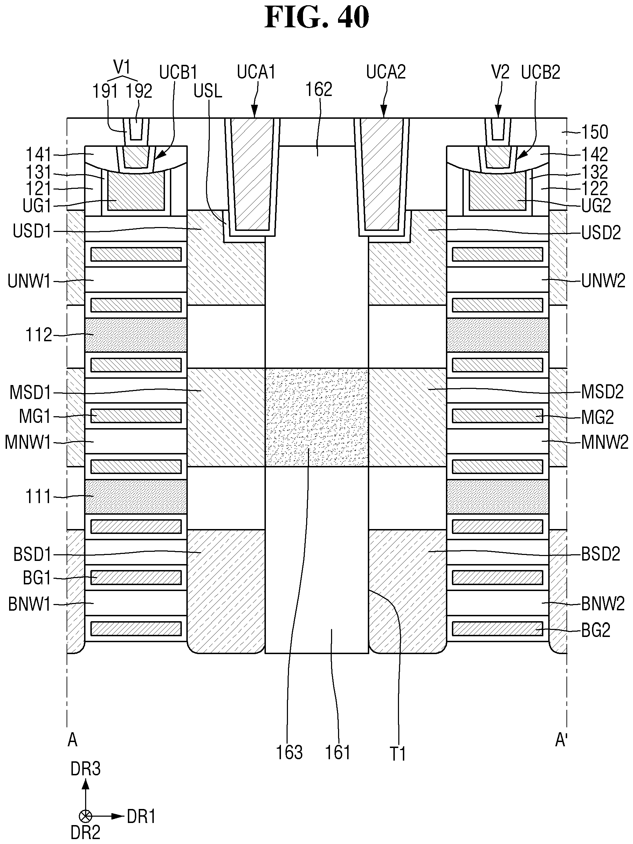

Referring to FIGS. 40 through 44, the substrate 10 and the active pattern 20 of FIGS. 35 through 39 may each be etched.

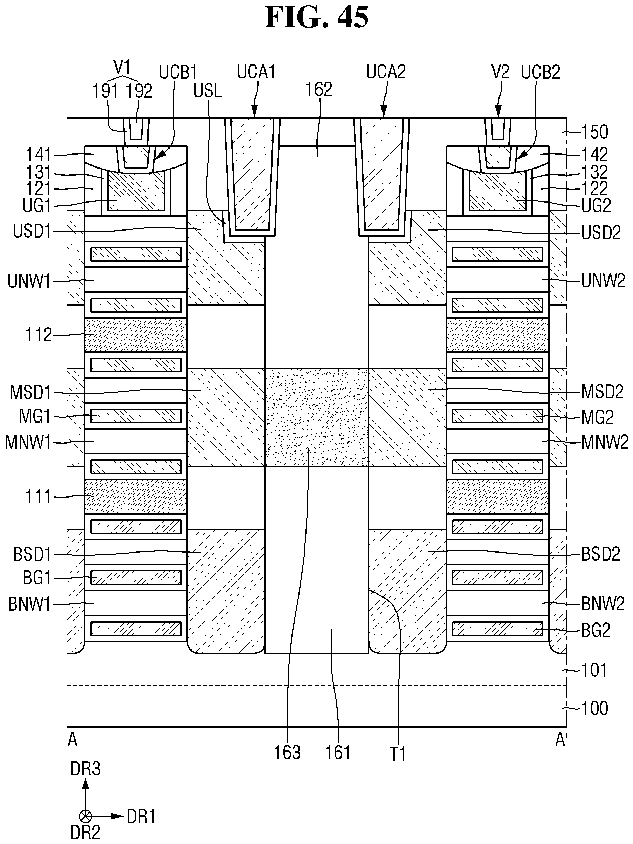

Referring to FIGS. 45 through 49, an insulating pattern 101 may be formed in an etched part of the active pattern 20 of FIGS. 35 through 39. Additionally, a lower interlayer insulating layer 100 may be formed in the etched portion of the substrate 10 of FIGS. 35 through 39. For example, the insulating pattern 101 and the lower interlayer insulating layer 100 may be formed through the same process.

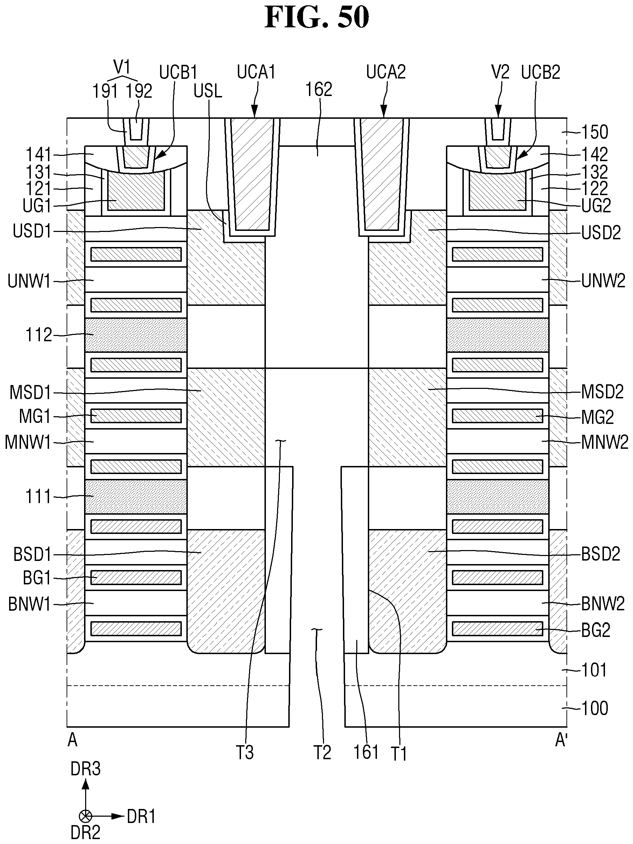

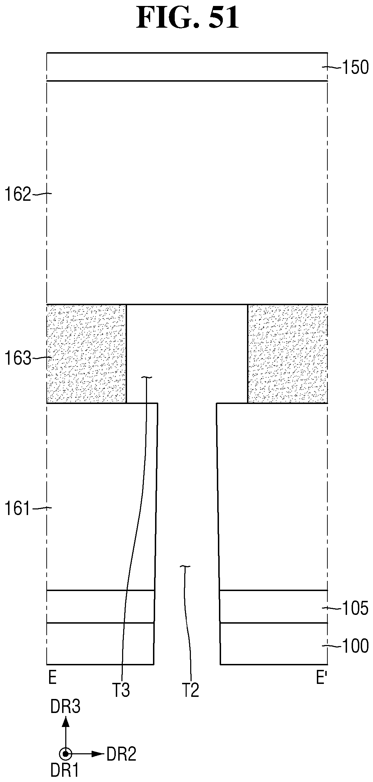

Referring to FIGS. 50 and 51, a second trench T2, which penetrates the lower interlayer insulating layer 100, the insulating pattern 101, the field insulating layer 105, and the first insulating layer 161 in the vertical direction DR3, may be formed. For example, the second trench T2 may extend to the bottom surface of the third insulating layer 163. Thereafter, part of the third insulating layer 163 may be etched through the second trench T2, forming a third trench T3 within the third insulating layer 163. For example, the sidewalls, in the first horizontal direction DR1, of each of the first and second middle source/drain regions MSD1 and MSD2 may be exposed through the third trench T3. In some implementations, the width, in the first horizontal direction DR1, of the third trench T3 may be greater than the width, in the first horizontal direction DR1, of the second trench T2. Also, the width, in the second horizontal direction DR2, of the third trench T3 may be greater than the width, in the second horizontal direction DR2, of the second trench T2.

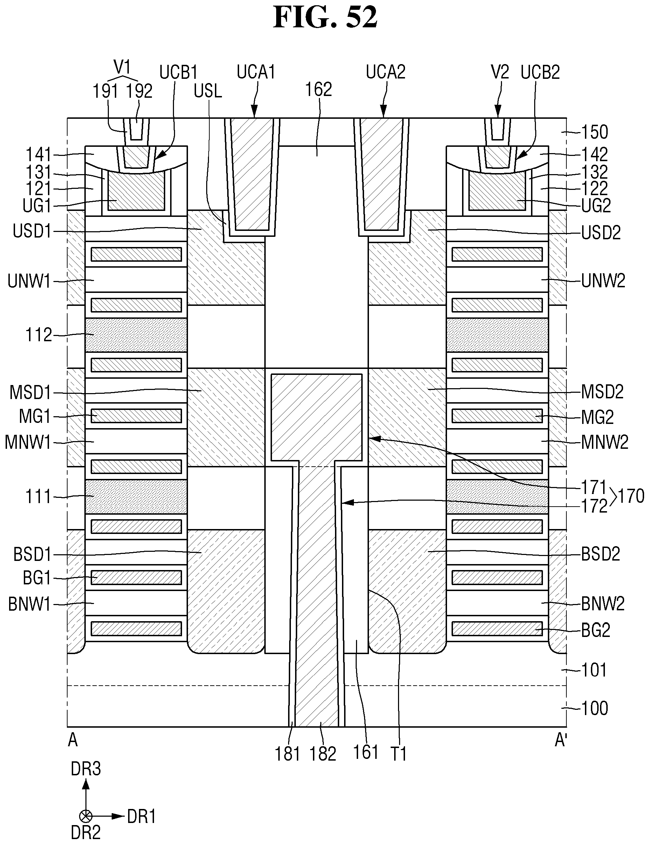

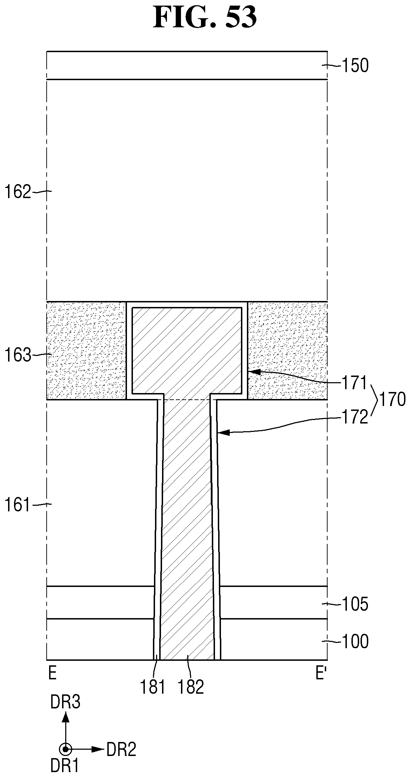

Referring to FIGS. 52 and 53, a middle source/drain contact 170 may be formed within each of the second and third trenches T2 and T3 of FIGS. 50 and 51. For example, a contact barrier layer 181 may be conformally formed along the surfaces of each of the second and second trenches T2 and T3 of FIGS. 50 and 51. Thereafter, a contact filling layer 182 may be formed to fill each of the second trench T2 and the third trench T3 between parts of the contact barrier layer 181.

As a result, a first portion 171 of the middle source/drain contact 170 may be formed within the third trench T3 of FIGS. 50 and 51, and a second portion 172 of the middle source/drain contact 170 may be formed within the second trench T2 of FIGS. 50 and 51. Additionally, a middle silicide layer MSL may be formed between the first portion 171 of the middle source/drain contact 170 and the first middle source/drain region MSD1 and between the first portion 171 of the middle source/drain contact 170 and the second middle source/drain region MSD2.

Referring to FIGS. 2 through 6, a first lower source/drain contact BCA1, which penetrates the lower interlayer insulating layer 100, the insulating pattern 101, and the field insulating layer 105 in the vertical direction DR3 and extends into the first lower source/drain region BSD1, may be formed. Similarly, a second lower source/drain contact BCA2, which penetrates the lower interlayer insulating layer 100, the insulating pattern 101, and the field insulating layer 105 in the vertical direction DR3 and extends into the interior of the second lower source/drain region BSD2, may be formed. A lower silicide layer BSL may be formed between the first lower source/drain contact BCA1 and the first lower source/drain region BSD1 and between the second lower source/drain contact BCA2 and the second lower source/drain region BSD2.

Additionally, a first lower gate contact BCB1, which is connected to the first lower gate electrode BG1 by penetrating the lower interlayer insulating layer 100 and the field insulating layer 105 in the vertical direction DR3, may be formed. In this manner, the semiconductor device of FIGS. 2 through 6 may be obtained.

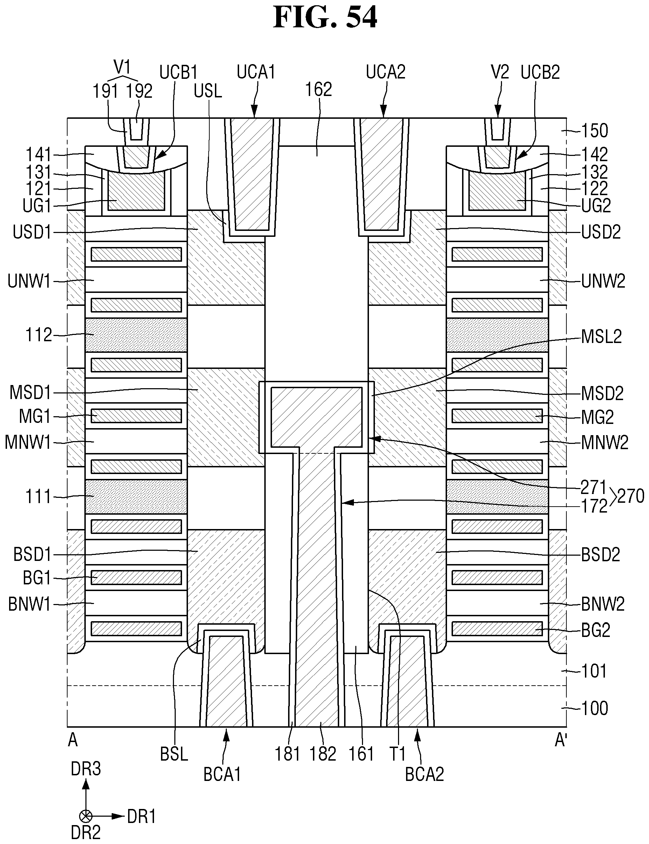

A semiconductor device according to some implementations will hereinafter be described with reference to FIG. 54, focusing mainly on the differences from the semiconductor device of FIGS. 1 through 6.

FIG. 54 is a cross-sectional view of a semiconductor device according to some implementations.

Referring to FIG. 54, a first portion 271 of a middle source/drain contact 270 may be formed between the bottom surface and the upper surface of a first middle source/drain region MSD1.

For example, the upper surface of the first portion 271 of the middle source/drain contact 270 may be formed lower than the upper surfaces of the first middle source/drain region MSD1 and a second middle source/drain region MSD2. Additionally, the bottom surface of the first portion 271 of the middle source/drain contact 270 may be formed higher than the bottom surfaces of the first and second middle source/drain regions MSD1 and MSD2. A middle silicide layer MSL2 may be disposed between the first portion 271 of the middle source/drain contact 270 and the first middle source/drain region MSD1. Moreover, the middle silicide layer MSL2 may also be disposed between the first portion 271 of the middle source/drain contact 270 and the second middle source/drain region MSD2.

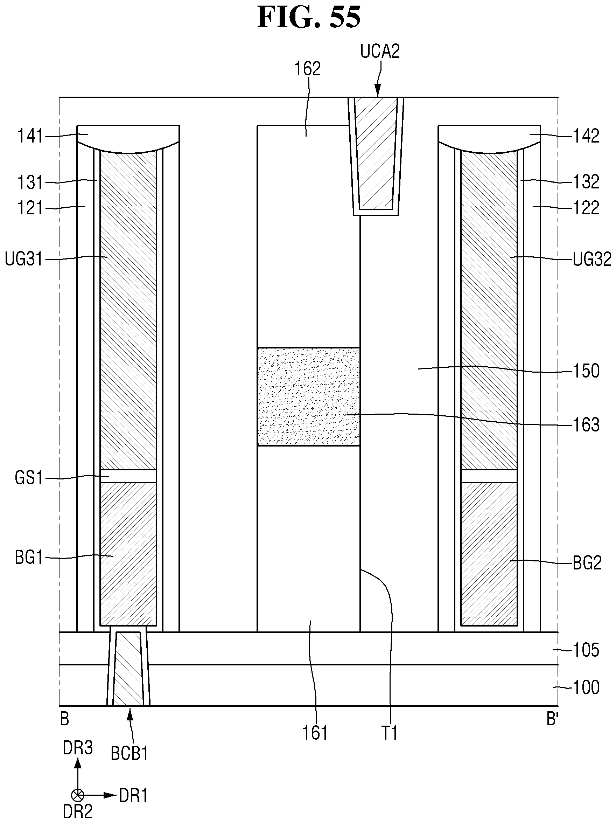

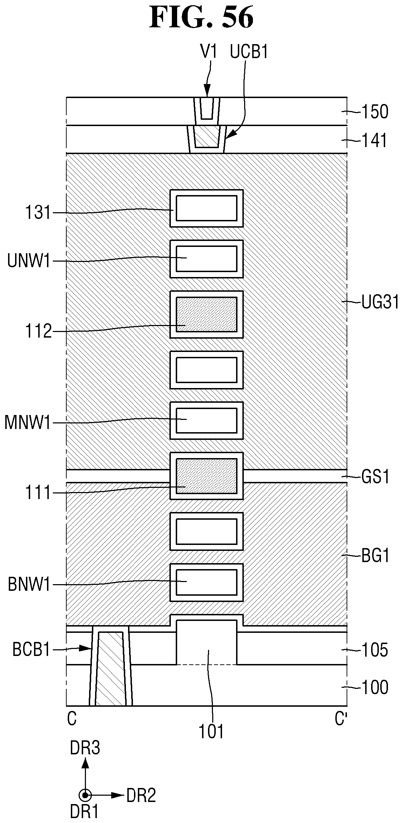

A semiconductor device according to some implementations will hereinafter be described with reference to FIGS. 55 and 56, focusing mainly on the differences from the semiconductor device of FIGS. 1 through 6.

FIGS. 55 and 56 are cross-sectional views of a semiconductor device according to some implementations.

Referring to FIGS. 55 and 56, each of a first gate electrode (BG1 and UG31) and a second gate electrode (BG2 and UG32) may include two individual gate electrodes.

For example, the first gate electrode (BG1 and UG31) may include a first lower gate electrode BG1 and a first upper gate electrode UG31. The first lower gate electrode BG1 may surround parts of first plurality of lower nanosheets BNW1 and part of a first stack separation layer 111. The first upper gate electrode UG31 may surround another part of the first stack separation layer 111 and may also surround first plurality of middle nanosheets MNW1, a second stack separation layer 112, and first plurality of upper nanosheets UNW1. The first upper gate electrode UG31 may be spaced apart in a vertical direction DR3 from the first lower gate electrode BG1. The first upper gate electrode UG31 and the first lower gate electrode BG1 may be separated in the vertical direction DR3 by a first gate separation layer GS1.

For example, the second gate electrode (BG2 and UG32) may include a second lower gate electrode BG2 and a second upper gate electrode UG32. The second lower gate electrode BG2 may surround parts of second plurality of lower nanosheets BNW2 and part of the first stack separation layer 111. The second upper gate electrode UG32 may surround another part of the first stack separation layer 111 and may also surround second plurality of middle nanosheets MNW2, the second stack separation layer 112, and second plurality of upper nanosheets UNW2. The second upper gate electrode UG32 may be spaced apart in the vertical direction DR3 from the second lower gate electrode BG2. The second upper gate electrode UG32 and the second lower gate electrode BG2 may be separated in the vertical direction DR3 by the first gate separation layer GS1.

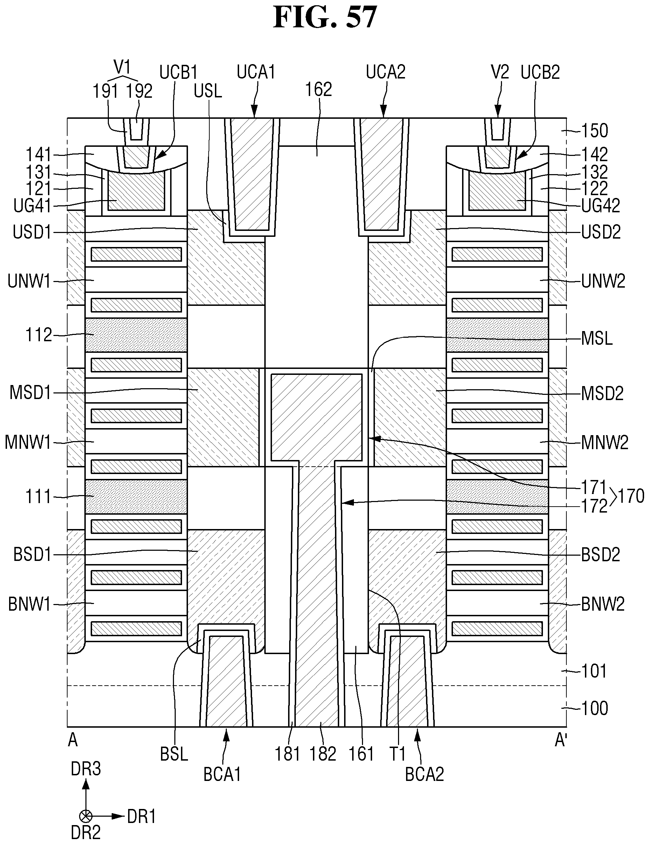

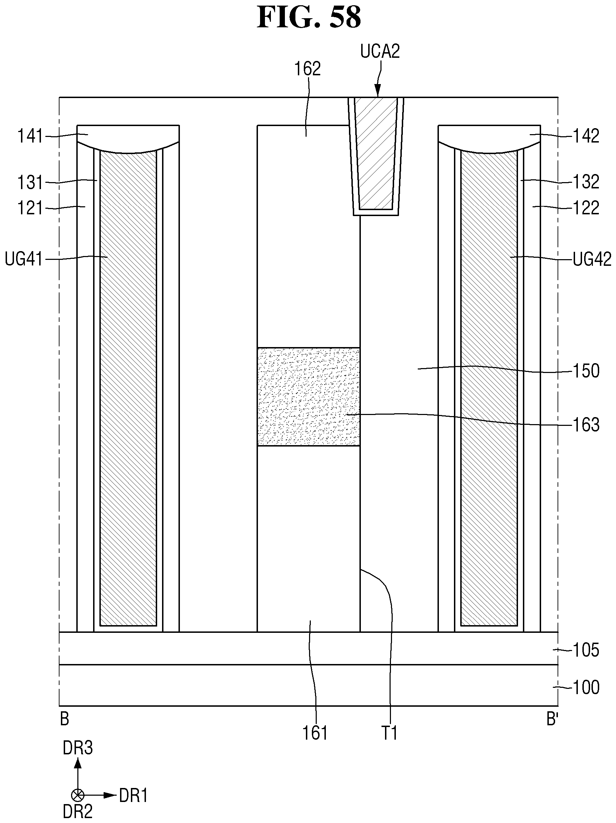

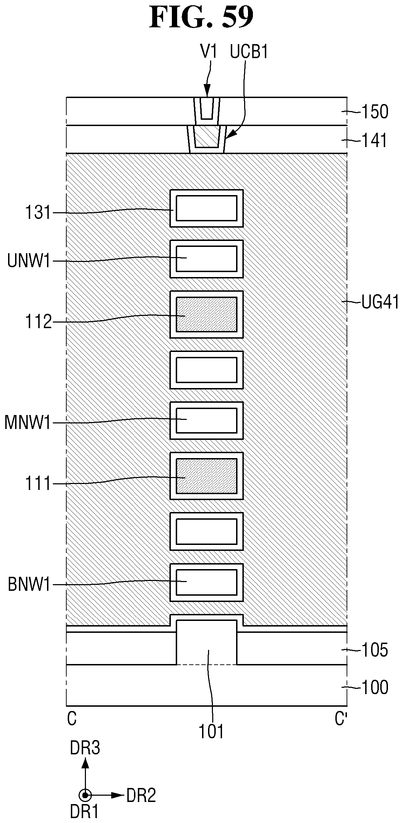

A semiconductor device according to some implementations will hereinafter be described with reference to FIGS. 57 through 59, focusing mainly on the differences from the semiconductor device of FIGS. 1 through 6.

FIGS. 57 through 59 are cross-sectional views of a semiconductor device according to some implementations.

Referring to FIGS. 57 through 59, a first gate electrode U41 may be integrally formed, and a second gate electrode U42 may be integrally formed.

For example, the first gate electrode U41 may include a single individual gate electrode. The first gate electrode U41 may surround a first plurality of lower nanosheets BNW1, a first stack separation layer 111, a first plurality of middle nanosheets MNW1, a second stack separation layer 112, and a first plurality of upper nanosheets UNW1. For example, the second gate electrode U42 may include a single individual gate electrode. The second gate electrode U42 may surround a second plurality of lower nanosheets BNW2, the first stack separation layer 111, a second plurality of middle nanosheets MNW2, the second stack separation layer 112, and a second plurality of upper nanosheets UNW2.

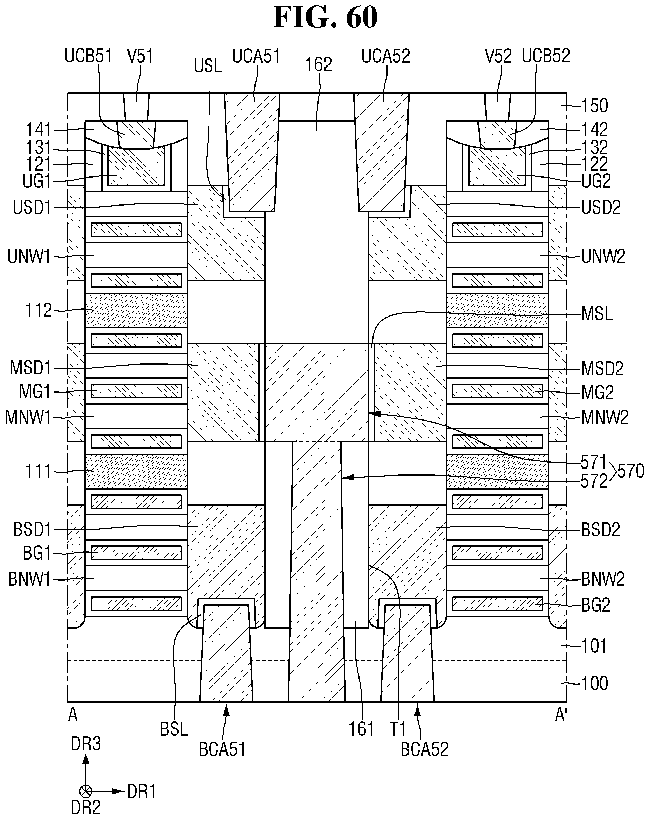

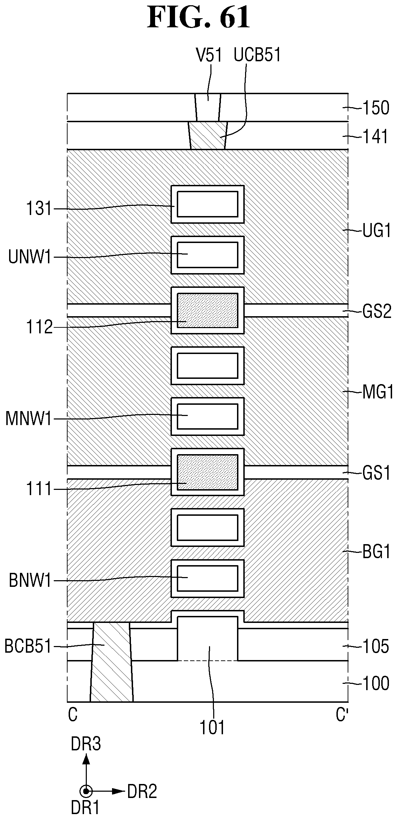

A semiconductor according to some implementations will hereinafter be described with reference to FIGS. 60 and 61, focusing mainly on the differences from the semiconductor device of FIGS. 1 through 6.

FIGS. 60 and 61 are cross-sectional views of a semiconductor device according to some implementations.

Referring to FIGS. 60 and 61, a middle source/drain contact 570 may be formed as a single film.

For example, first and second portions 571 and 572 of the middle source/drain contact 570 may be formed as single films. The first and second portions 571 and 572 of the middle source/drain contact 570 may be integrally formed. Additionally, first and second lower source/drain contacts BCA51 and BCA52, first and second upper source/drain contacts UCA51 and UCA52, a first lower gate contact BCB51, first and second upper gate contacts UCB51 and UCB52, and first and second vias V51 and V52 may be formed as single films.

For example, the middle source/drain contact 570, the first and second lower source/drain contacts BCA51 and BCA52, the first and second upper source/drain contacts UCA51 and UCA52, the first lower gate contact BCB51, the first and second upper gate contacts UCB51 and UCB52, and the first and second vias V51 and V52 may include one of Al, W, Co, Ru, or Mo.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While implementations have been described with reference to the attached drawings , it should be understood that the present disclosure is not limited to these embodiments. The present disclosure can be manufactured in various different forms, and those of ordinary skill in the art will appreciate that the implementations can be carried out in other specific forms without changing the essential features of the present disclosure. Therefore, the implementations described above should be considered in all respects as illustrative and not restrictive.

## Claims

1. A semiconductor device comprising:
a lower interlayer insulating layer;
an insulating pattern extending in a first horizontal direction on an upper surface of the lower interlayer insulating layer;
a first plurality of lower nanosheets and a second plurality of lower nanosheets spaced apart from each other in the first horizontal direction on the insulating pattern;
a first plurality of middle nanosheets and a second plurality of middle nanosheets spaced apart from each other in the first horizontal direction, wherein the first plurality of middle nanosheets and the second plurality of middle nanosheets are arranged on the first plurality of lower nanosheets and the second plurality of lower nanosheets, respectively;
a first plurality of upper nanosheets and a second plurality of upper nanosheets spaced apart from each other in the first horizontal direction, wherein the first plurality of upper nanosheets and the second plurality of upper nanosheets are arranged on the first plurality of middle nanosheets and the second plurality of middle nanosheets, respectively;
a first stack separation layer disposed between the first plurality of lower nanosheets and the first plurality of middle nanosheets and between the second plurality of lower nanosheets and the second plurality of middle nanosheets;
a second stack separation layer disposed between the first plurality of middle nanosheets and the first plurality of upper nanosheets and between the second plurality of middle nanosheets and the second plurality of upper nanosheets;
a first gate electrode extending on the insulating pattern in a second horizontal direction different from the first horizontal direction, wherein the first gate electrode surrounds the first plurality of lower nanosheets, the first plurality of middle nanosheets, and the first plurality of upper nanosheets;
a second gate electrode extending on the insulating pattern in the second horizontal direction, wherein the second gate electrode is spaced apart from the first gate electrode in the first horizontal direction, and the second gate electrode surrounds the second plurality of lower nanosheets, the second plurality of middle nanosheets and the second plurality of upper nanosheets;
a first middle source/drain region contacting both sidewalls of the first plurality of middle nanosheets in the first horizontal direction;
a second middle source/drain region contacting both sidewalls of the second plurality of middle nanosheets in the first horizontal direction; and
a middle source/drain contact disposed between the first middle source/drain region and the second middle source/drain region, wherein the middle source/drain contact is electrically connected to the first and second middle source/drain regions, and the middle source/drain contact penetrates the lower interlayer insulating layer and the insulating pattern in a vertical direction,
wherein an upper surface of the middle source/drain contact is formed lower than a bottom surface of a lowermost nanosheet of the first plurality of upper nanosheets.

2. The semiconductor device of claim 1,
wherein the middle source/drain contact includes a first portion disposed between the first and second middle source/drain regions, and a second portion disposed below the first portion, and
wherein a width of the first portion of the middle source/drain contact in the first horizontal direction is greater than a width of the second portion of the middle source/drain contact in the first horizontal direction.

3. The semiconductor device of claim 2, wherein a width of the first portion of the middle source/drain contact in the second horizontal direction is greater than a width of the second portion of the middle source/drain contact in the second horizontal direction.

4. The semiconductor device of claim 2 or claim 3, further comprising:
a first lower source/drain region contacting both sidewalls of the first plurality of lower nanosheets in the first horizontal direction;
a second lower source/drain region contacting both sidewalls of the second plurality of lower nanosheets in the first horizontal direction; and
a first insulating layer extending in the second horizontal direction between the first and second lower source/drain regions, wherein the first insulating layer surrounds sidewalls of the second portion of the middle source/drain contact.

5. The semiconductor device of claim 4, further comprising:
a second insulating layer disposed on an upper surface of the first insulating layer, wherein the second insulating layer contacts both sidewalls of the first portion of the middle source/drain contact in the second horizontal direction, and wherein the second insulating layer includes a material different from of a material of the first insulating layer.

6. The semiconductor device of claim 4 or claim 5,
wherein the first and second lower source/drain regions are formed in a P-type metal-oxide semiconductor region, and
wherein the first and second middle source/drain regions are formed in an N-type metal-oxide semiconductor region.

7. The semiconductor device of any preceding claim, wherein the first gate electrode includes:
a first lower gate electrode surrounding the first plurality of lower nanosheets,
a first middle gate electrode spaced apart from the first lower gate electrode in the vertical direction, the first middle gate electrode surrounding the first plurality of middle nanosheets, and
a first upper gate electrode spaced apart from the first middle gate electrode in the vertical direction, the first upper gate electrode surrounding the first plurality of upper nanosheets.

8. The semiconductor device of any of claims 1 to 6, wherein the first gate electrode includes:
a first lower gate electrode surrounding the first plurality of lower nanosheets, and
a first upper gate electrode spaced apart from the first lower gate electrode in the vertical direction, the first upper gate electrode surrounding the first plurality of middle nanosheets and the first plurality of upper nanosheets.

9. The semiconductor device of any preceding claim, wherein the first gate electrode is integrally formed.

10. The semiconductor device of any preceding claim, wherein the middle source/drain contact includes: a contact barrier layer forming sidewalls and an upper surface of the middle source/drain contact, and a contact filling layer filling a gap in the contact barrier layer.

11. A semiconductor device of any preceding claim, comprising:
a first insulating layer extending in the second horizontal direction between the first plurality of lower nanosheets and the second plurality of lower nanosheets,
wherein the middle source/drain contact includes:
a first portion disposed on an upper surface of the first insulating layer between the first and second middle source/drain regions, and
a second portion connected to the first portion by penetrating the first insulating layer in a vertical direction, wherein the first portion is electrically connected to the first and second middle source/drain regions,
wherein a width of the first portion of the middle source/drain contact in the first horizontal direction is greater than a width of the second portion of the middle source/drain contact in the first horizontal direction.

12. The semiconductor device of claim 11, further comprising:
a first upper source/drain region contacting both sidewalls of the first plurality of upper nanosheets in the first horizontal direction;
a second upper source/drain region contacting both sidewalls of the second plurality of upper nanosheets in the first horizontal direction;
a second insulating layer extending in the second horizontal direction between the first and second upper source/drain regions, wherein the second insulating layer contacts an upper surface of the first portion of the middle source/drain contact; and
a third insulating layer disposed between the first and second insulating layers, wherein the third insulating layer contacts both sidewalls of the first portion of the middle source/drain contact in the second horizontal direction, and the third insulating layer includes a material different from a material of each of the first and second insulating layers.

13. The semiconductor device of claim 12,
wherein the upper surface of the first portion of the middle source/drain contact is formed on the same plane as an upper surface of the third insulating layer, and
wherein a bottom surface of the first portion of the middle source/drain contact is formed on the same plane as a bottom surface of the third insulating layer.

14. The semiconductor device of any of claims 11 to 13,
wherein an upper surface of the first portion of the middle source/drain contact is formed on the same plane as an upper surface of the first middle source/drain region, and
wherein a bottom surface of the first portion of the middle source/drain contact is formed on the same plane as a bottom surface of the first middle source/drain region.

15. The semiconductor device of any of claims 11 to 13,
wherein an upper surface of the first portion of the middle source/drain contact is formed lower than an upper surface of the first middle source/drain region, and
wherein a bottom surface of the first portion of the middle source/drain contact is formed higher than a bottom surface of the first middle source/drain region.
